# EUROPEAN PATENT APPLICATION

(11) **EP 4 776 071 A1**
(43) Date of publication of application: **15.07.2026**
(21) Application number: 24862920.6
(22) Date of filing: 06.09.2024
(51) Int. Cl.: G03F 7/30, A46B 9/02, B41C 1/055, B41N 1/00

(54) **TRANSPLANTED FLAT BRUSH OR TRANSPLANTED ROLL BRUSH, DEVELOPER PROCESSING SYSTEM, AND METHOD FOR MANUFACTURING PRINTING PLATE**

(30) Priority: 07.09.2023 JP 2023145173; 26.12.2023 JP 2023219233
(71) Applicant: ASAHI KASEI KABUSHIKI KAISHA, Tokyo 100-0006 (JP)
(72) Inventor: SAITO, Takanori, Tokyo 100-0006 (JP); TSUNEZAWA, Kenta, Tokyo 100-0006 (JP)
(74) Representative: Strehl & Partner mbB
(86) International application number: PCT/JP2024/032100
(87) International publication number: WO 2025/053271

(57) **Abstract**

To decrease the adhesion of debris, to easily remove adhering debris, and to sufficiently remove uncured resin and the like, the present disclosure provides an implanted flat brush (50) or implanted roll brush. The implanted flat brush (50) or implanted roll brush is a brush used for a developing step of a printing plate, which is made through an exposing step and the developing step. In the brush, bristle bundles (53) are implanted at equal intervals into a plurality of implanting holes (52) formed in a brush base (51), and in a case where a smallest base area formed by four bristle bundles (53) in close proximity is S [mm2] and a bristle height of the bristle bundle (53) is L [mm], a debris adhesion coefficient S/L is from 6.00 to 12.00.

## Description

### Technical Field

The present invention relates to an implanted flat brush or implanted roll brush used for a developing step of a printing plate, a developer processing system, and a method for manufacturing a printing plate.

### Background Art

In a step of developing a printing plate, which is made using a photosensitive resin plate through various steps, i.e., exposure, development, and rinsing, uncured resin and the like, i.e., unexposed portions, are washed away and removed using a roll brush, while supplying a water-based developer (see Patent Literature 1). Besides the roll brush which rotates, other brushes, such as a flat brush, which is flat-shaped, may be used.

For the roll brush, a so-called channel roll brush may be used, in which bristle bundles are joined together using galvanized groove steel (channel) or the like, and are disposed helically may be used, or a brush generated by implanting bristle bundles into a flat brush base (implanted flat brush). However, if the developing step is repeated using such a brush, development sludge, which is called debris, adheres and is deposited on the bristle bundles, and eventually grows toward the outer side in an icicle shape. This problem may appear more clearly when the implanting pitch is small and the implantation of the bristle bundles is dense.

To solve this problem, a roll brush may have a resin brush base, which is a main body of the brush. Whereby the phenomena of debris adhering to the channel brush, as described above, is improved.

### Citation List

### Patent Literature

Patent Literature 1: WO 2020/158380

### Summary of Invention

### Technical Problem

However even if a resin brush base is used for the implanted roll brush, adhering debris may not be sufficiently decreased in some cases. If removal of the adhering debris is difficult, operability diminishes. This problem could occur even in the case of an implanted flat brush of which brush base is flat.

With the foregoing in view, it is an object of the present invention to provide an implanted flat brush or implanted roll brush, a developer processing system, and a method for manufacturing a printing plate, to decrease the adhesion of debris, to remove adhering debris easily, and to sufficiently remove uncured resin and the like.

### Solution to Problem

After various examinations and tests, the present inventors found ways to solve the above problem. The present invention is based on the finding, and an aspect thereof is an implanted flat brush or implanted roll brush used for a developing step of a printing plate, which is made through an exposing step and the developing step. In the implanted flat brush or implanted roll brush, bristle bundles are implanted at equal intervals into a plurality of implanting holes formed in a brush base, and in a case where a smallest base area formed by four bristle bundles in close proximity is S [mm2] and a bristle height of the bristle bundle is L [mm], a debris adhesion coefficient S/L is 6.00 or more and 12.00 or less.

As a result of repeating various examinations and tests, as described above, it was determined that even in the case of an implanted flat brush or implanted roll brush of which brush base is formed of resin, adhesion of debris, removal of debris, generation of chipping and the like are influenced by various factors, such as pitch density of implanting holes, bristle height, thickness of a bristle, and diameter and depth of an implanting hole, especially by the pitch density of the implanting holes. Focusing on such factors, it was determined that performance, in terms of adhesion prevention of debris and removal of debris, improves or remains at an appropriate level by setting the density of arranging the bristle bundles to the above mentioned range, and setting the debris adhesion coefficient S/L to the above mentioned range.

In the above mentioned implanted flat brush or implanted roll brush, it is preferable that the base area formed by the four bristle bundles in close proximity is110.00 [mm2] or more and 200.00 [mm2] or less, a distance between the bristle bundle and another bristle bundle closest to the bristle bundle is 4.00 [mm] or more and 16.00 [mm] or less, in the region formed by the four bristle bundles in close proximity, a ratio of the bristle height L of the bristle bundle and a distance between two implanting holes in close proximity is 0.70 or more and 1.30 or less, the bristle height L of the bristle bundle is 8.00 [mm] or more and20.00 [mm] or less, a number of the implanting holes is 4000/m2 or more and 15000/m2 or less, a depth of the implanting hole is 5 mm or more and 20 mm or less, and a ratio of the depth of the implanting holes and the bristle height is 5.0:13.0 or more and 30.0:13.0 or less.

Another aspect of the present invention is an implanted flat brush or implanted roll brush used for a developing step of a printing plate, which is made through an exposing step and the developing step. Here brush bundles are implanted into a plurality of implanting holes formed in a brush base, a bristle height of the bristle bundle is 8 mm or more and 20 mm or less, a depth of the implanting hole is 5 mm or more and 20 mm or less, a ratio of the depth of the implanting hole and the bristle height is 5.0:13.0 or more and 30.0:13.0 or less, and a number of the implanting holes is 4000/m2 or more and 15000/m2 or less.

In the above mentioned implanted flat brush or implanted roll brush, a rinsing step may be further included to make the printing plate.

In the above mentioned implanted flat brush or implanted roll brush, it is preferable that cleaning holes, which are discharge holes for cleaning solution, are formed on a flat brush base, the cleaning holes are disposed in a zigzag arrangement, a distance between the cleaning holes in close proximity is 65.00 [mm] or more and 80.00 [mm] or less, and a number of bristle bundles between the cleaning holes in close proximity is 3 or more and 7 or less.

In the above mentioned implanted flat brush or implanted roll brush, it is preferable that in the bristle bundles which are disposed in a line at equal intervals, a distance between bristle bundles which are adjacent to each other across the cleaning hole is 3.00 times or less of a distance between bristle bundles which are adjacent to each other not across the cleaning hole.

In the above mentioned implanted flat brush or implanted roll brush, it is preferable that a bristle diameter of each bristle of the bristle bundle is 80 µm or more and 400 µm or less, a bristle amount of the bristle bundle is 500 g/m2 or more and 4000 g/m2 or less, a hole diameter of the implanting hole is1.0 mm or more and 6.0 mm or less, a number of bristles is 100/hole or more and 500/hole or less, a ratio of the depth of the hole and the hole diameter is 5.0:4.2 or more and 30:4.2 or less, the brush base is formed of resin, and a material of the brush base is any of or two or more of PVC, PP and ABS, and a material of the bristle is any of 66 NY, 612 NY, 610 NY and PP.

In the above mentioned implanted flat blush, it is preferable that the brush base is rectangular, the ratio of a short side and a long side of which is1:6.00 or more and 1:10.00 or less.

Another aspect of the present invention is a method for manufacturing a printing plate, the method including an exposing step and a developing step. In an implanted flat brush or implanted roll brush used in the developing step, bristle bundles are implanted at equal intervals into a plurality of implanting holes formed in a brush base, and in a case where a smallest base area formed by four bristle bundles in close proximity is S [mm2] and a bristle height of the bristle bundle is L [mm], a debris adhesion coefficient S/L is 6.00 or more and 12.00 or less.

Another aspect of the present invention is a method for manufacturing a printing plate, the method including an exposing step and a developing step. In an implanted flat brush or implanted roll brush used in the developing step, bristle bundles are implanted into a plurality of implanting holes formed in a brush base, a bristle height of the bristle bundle is 8 mm or more and 20 mm or less, a depth of the implanting hole is 5 mm or more an 20 mm or less, a ratio of the depth of the implanting hole and the bristle height is 5.0:13.0 or more and30.0:13.0, and a number of the implanting holes is4000/m2 or more and 15000/m2 or less.

In the above mentioned method for manufacturing a printing plate, it is preferable that a rotating speed of the brush in the developing step is 3 rpm or more and 25 rpm or less, and an oscillating speed during oscillating rotation is20 rpm or more and 150 rpm or less.

In the above mentioned method for manufacturing a printing plate, it is preferable that a contact pressure of the brush to the printing plate in the developing step is 50 g/cm2 or more and 800 g/cm2 or less, and a biting amount of the brush to the printing plate is 1 mm or more and 5 mm or less.

The above mentioned method for manufacturing a printing plate may further include the steps of: selecting a brush that is appropriate for design and/or quality of the plate; and adjusting a brush contact pressure by installing a spacer at a root of the brush base.

In the above mentioned method for manufacturing a printing plate, it is preferable that the flat brush includes two or more types of regions of which thickness, length and material of a bristle are different.

In the above mentioned method for manufacturing a printing plate, it is preferable that developer is used in the developing step, and the developer contains a surface active agent of which content percentage is 0.00 wt% or more and 4.20 wt% or less.

Another aspect of the present invention is a developer processing system used for a developing step of a printing plate, which is made through an exposing step and the developing step, the system being a developer processing system being a system including: the abovementioned implanted flat brush or implanted roll brush; a developer tank; and a developer filtering apparatus, which includes at least one filter. In an unexposed resin mass balance in a case where an unexposed resin is supplied, a total of resin existing in the developer filtering apparatus and resin floating in the developer tank is 70.0 wt% or more and 95.0wt% or less with respect to the supplied unexposed resin.

In the above mentioned developer processing system, it is preferable that the developer tank includes a developer suction apparatus, and the developer filtering apparatus filters developer sucked by the developer suction apparatus, and includes: a dispersoid filter which aggregates dispersoid dispersed in the developer; and an aggregate filter which removes aggregates aggregated by the dispersoid filter.

### Advantageous Effect of Invention

According to the present invention, adhesion of debris can be decreased, adhering debris can be reduced easily, and uncured resin and the like can be sufficiently removed.

### Brief Description of Drawings

[Figure 1] Figure 1 is a diagram depicting a configuration of each implanted roll brush of Figure 1(A) "dense channel", Figure 1(B) "dense implanting", Figure 1(C) "10 mm implanting pitch (horizontal)", Figure 1(D) "12 mm implanting pitch (horizontal)", Figure 1(E) "12 mm 612 implanting pitch (horizontal)", Figure 1(F) "13 mm implanted bristle height", and Figure 1(G) "10 mm implanted bristle height" (contents of the naming of each implanted roll brush will be described later).
[Figure 2] Figure 2 is a table indicating a bristle weight, bristle material, bristle height, thickness hole diameter of implanting hole, number of holes, hole pitch and base material of each implanted roll brush, where (A) "dense channel", (B) "dense implanting", (C) "10 mm implanting pitch (horizontal)", (D) "12 mm implanting pitch (horizontal)", (E) "12 mm 612 implanting pitch (horizontal)", (F) "13 mm implanted bristle height", and (G) "10 mm implanted bristle height".
[Figure 3] Figure 3 is a diagram depicting a state of each implanted roll brush, where Figure 3A "dense channel", Figure 3B "dense implanting", Figure 3C "10 mm implanting pitch (horizontal)", Figure 3D "12 mm implanting pitch (horizontal)", Figure 3F "13 mm implanted bristle height", and Figure 3G "10 mm implanted bristle height".
[Figure 4] Figure 4a is a graph indicating the resin development amount for each developing time of each implanted roll brush, where (A) "dense channel", (B) "dense implanting", (C) "10 mm implanting pitch (horizontal)", (D) "12 mm implanting pitch (horizontal)", (F) "13 mm implanted bristle height", and (G) "10 mm implanted bristle height", and Figure 4b is a diagram for describing the thickness RD of uncured resin or the like after exposing the photosensitive resin plate by an ultraviolet ray.
[Figure 5] Figure 5 is a graph indicating a depth of a concave portion (white line: 500 µm width) of a photosensitive resin plate after cleaning by each implanted roll brush, where (A) "dense channel", (B) "dense implanting", (C) "10 mm implanting pitch (horizontal)", (D) "12 mm implanting pitch (horizontal)", (F) "13 mm implanted bristle height", and (G) "10 mm implanted bristle height".
[Figure 6] Figure 6 is a graph indicating a depth of a concave portion (white line: 100 µm width) of a photosensitive resin plate after cleaning by each implanted roll brush, where Figure 6A "dense channel", Figure 6B "dense implanting", Figure 6C "10 mm implanting pitch (horizontal)", Figure 6D "12 mm implanting pitch (horizontal)", Figure 6F "13 mm implanted bristle height", and Figure 6G "10 mm implanted bristle height".
[Figure 7] Figure 7 is an image indicating photosensitive resin plates before developing processing, disposed at the center and positions closer to the side.
[Figure 8] Figure 8 is a diagram for describing the bit amount of a brush to the printing plate, where Figure 8A is a top view of a cleaning apparatus, Figure 8B is a side view of the cleaning apparatus, Figure 8C is an enlarged view of an actual plate after developing processing, Figure 8D is a side view of the plate, and Figure 8E is a graph indicating the correlation between the biting amount of the brush and contact surface width of the brush (width of a mark indicated by one brush contacting the unexposed photosensitive resin plate).
[Figure 9] Figure 9 is an enlarged image of the photosensitive resin plates for evaluating the generation of chipping after cleaning using each roll brush, where Figure 9A "dense channel", Figure 9B "dense implanting", Figure 9C "10 mm implanting pitch (horizontal)", Figure 9D "12 mm implanting pitch (horizontal)", Figure 9F "13 mm implanted bristle height", and Figure 9G "10 mm implanted bristle height".
[Figure 10] Figure 10 is an enlarged image of the photosensitive resin plates for indicating the generation of chipping after cleaning using each roll brush of Figure 10A "dense channel", Figure 10B "dense implanting", Figure 10C "10 mm implanting pitch (horizontal)", Figure 10D "12 mm implanting pitch (horizontal)", Figure 10F "13 mm implanted bristle height", and Figure 10G "10 mm implanted bristle height".
[Figure 11] Figure 11 is an enlarged image of the photosensitive resin plates for evaluating the generation of chipping after cleaning using each roll brush, where Figure 11A "dense channel", Figure 11B "dense implanting", Figure 11C "10 mm implanting pitch (horizontal)", Figure 11D "12 mm implanting pitch (horizontal)", Figure 11F "13 mm implanted bristle height", and Figure 11G "10 mm implanted bristle height".
[Figure 12] Figure 12 is an enlarged image of the photosensitive resin plates for confirming the depth of the concave portion (white line: 100 µm width) of the photosensitive resin plate after cleaning using each roll brush, where Figure 12A "dense channel", Figure 12B "dense implanting", Figure 12C "10 mm implanting pitch (horizontal)", Figure 12D "12 mm implanting pitch (horizontal)", Figure 12F "13 mm implanted bristle height", and Figure 12G "10 mm implanted bristle height".
[Figure 13] Figure 13 is an enlarged image of the photosensitive resin plates for confirming the depth of the concave portion (white line: 500 µm width) of the photosensitive resin plate after cleaning using each roll brush, where Figure 13A "dense channel", Figure 13B "dense implanting", Figure 13C "10 mm implanting pitch (horizontal)", Figure 13D "12 mm implanting pitch (horizontal)", Figure 13F "13 mm implanted bristle height", and Figure 13G "10 mm implanted bristle height".
[Figure 14] Figure 14 is an enlarged image of the photosensitive resin plates under 150 Ipi and 5% conditions after cleaning using each roll brush, where Figure 14A "dense channel", Figure 14B "dense implanting", Figure 14C "10 mm implanting pitch (horizontal)", Figure 14D "12 mm implanting pitch (horizontal)", Figure 14F "13 mm implanted bristle height", and Figure 14G "10 mm implanted bristle height".
[Figure 15] Figure 15 is an enlarged image of the photosensitive resin plates under 150 Ipi and 75% conditions after cleaning using each roll brush, where Figure 15A "dense channel", Figure 15B "dense implanting", Figure 15C "10 mm implanting pitch (horizontal)", Figure 15D "12 mm implanting pitch (horizontal)", Figure 15F "13 mm implanted bristle height", and Figure 15G "10 mm implanted bristle height".
[Figure 16] Figure 16 is an example of the arrangement patterns of implanted holes of the implanted roll brush, where Figure 16A is a parallel type, Figure 16B is a zigzag type, Figure 16C is a V-shaped type and Figure 16D is a spiral type.
[Figure 17] Figure 17 is a pointed tip shape of the implanted roll brush, and Figure 17A is a case where the tip is inclined, and Figure 17B is a case where the tip is tapered.
[Figure 18] Figure 18 is a table of parameter values of 5 types of implanted flat brushes (brush 1 to brush 5), indicating various parameters (debris adhesion coefficient, bristle height [mm], brush arrangement, shortest distance between bristle bundles [mm], base area [mm2], cleaning time [sec.], bristle bundle diameter [mm], bristle bundle density (/m2), and bristle amount (kg/m2).
[Figure 19] Figure 19 is a perspective view depicting a configuration of brush 5.
[Figure 20] Figure 20 is a plan view depicting a configuration of brush 5.
[Figure 21] Figure 21 is an enlarged plan view depicting a configuration of brush 1.
[Figure 22] Figure 22 is an enlarged plan view depicting a configuration of brush 2.
[Figure 23] Figure 23 is an enlarged plan view depicting a configuration of brush 3.
[Figure 24] Figure 24 is an enlarged plan view depicting a configuration of brush 4 or 5.
[Figure 25] Figure 25A is a graph indicating the time for each brush 1 to 5 to clean a printing plate for 0.55 mm. Figure 25B is a table indicating a depth of a microcell after cleaning using brushes 1 and 5.
[Figure 26] Figure 26 is a graph indicating the debris adhesion amount to bushes 1 to 5 respectively after cleaning 100 plates.
[Figure 27] Figure 27 is a graph indicating a mass balance of unexposed resin removed in the developing step, in the case of brush 1 and brush 5 respectively.
[Figure 28] Figure 28 is a diagram for describing the parallel arrangement.
[Figure 29] Figure 29 is a diagram for describing the zigzag arrangement.
[Figure 30] Figure 30 is a diagram depicting an example of the printing plate developing step system.

### Description of Embodiments

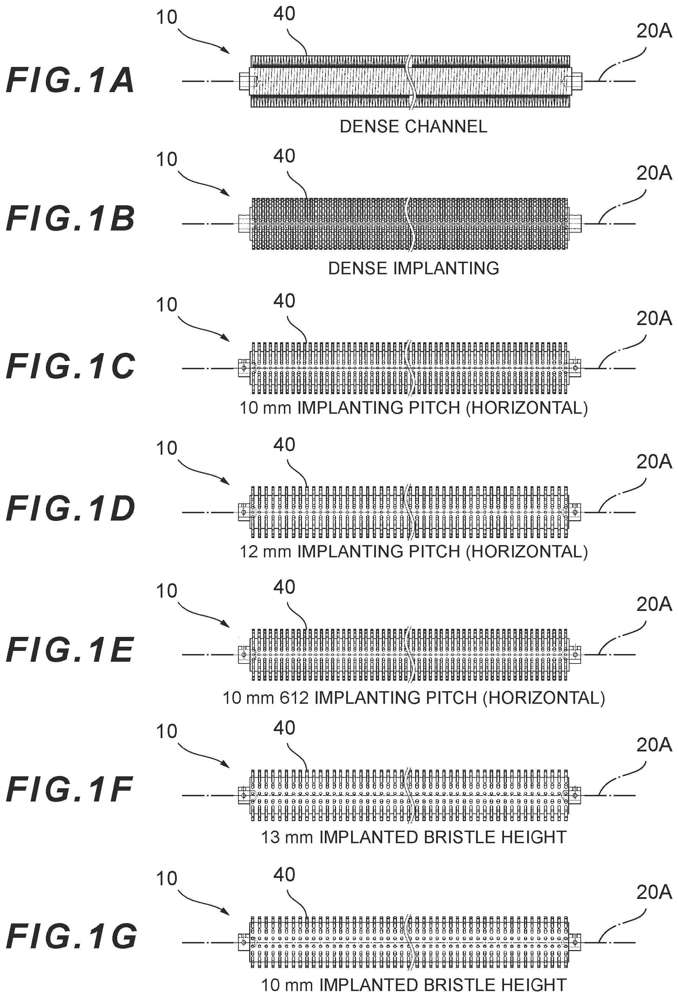

Embodiments of the configurations of the present invention will now be described in detail with reference to the drawings (see Figure 1 and the like).

### <<Embodiment 1 of invention>>

Roll brushes 10, excluding (A), are used in a cleaning step in making a printing plate. In the cleaning step, uncured resin and the like (unexposed portions) are washed out and removed while applying water-based developer. The implanted roll brushes 10, excluding (A) in the present embodiment, are configured by implanting bristle bundles 40 into a plurality of implanting holes 30 in a brush base 20 which is formed of resin.

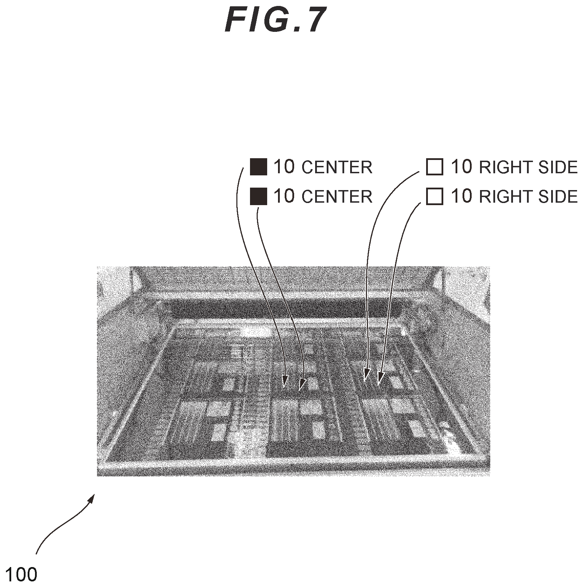

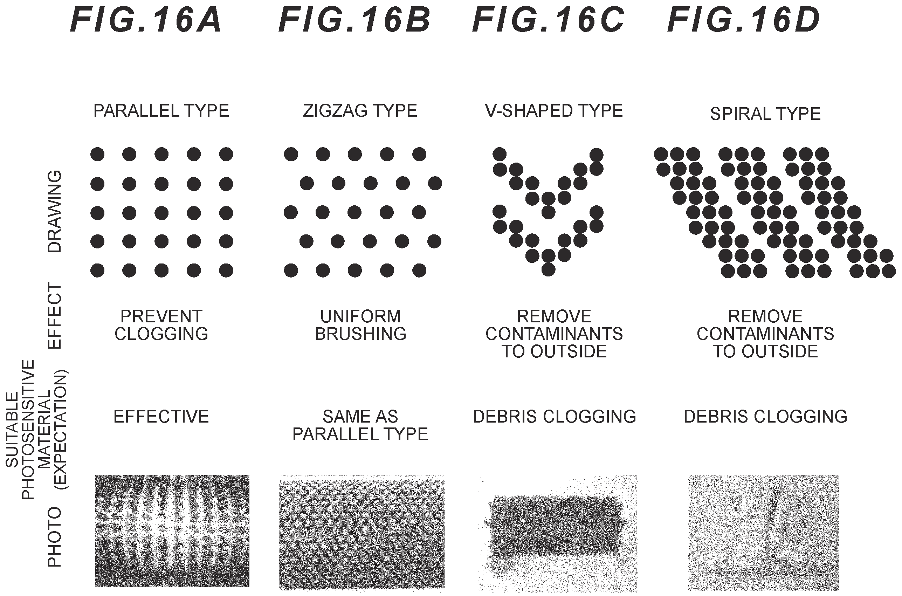

The brush base 20 is cylindrical and configured to rotate around a rotation shaft 20A (see Figure 1 and the like). On the surface of the brush base 20, a plurality of implanting holes 30 are formed in a predetermined pattern, such as parallel type, a zigzag type (type where half pitch is shifted for each example, or a hole is arranged at each vertex of an equilateral triangle), a V-shaped type and a spiral type (see Figure 16). A bristle bundle 40 constituted of a plurality of bristles is implanted into each of the implanting holes 30. A plurality of the implanted roll brushes 10 having such a configuration are arranged in a cleaning apparatus 100 for a printing plate (see Figure 7).

### <<Example 1>>

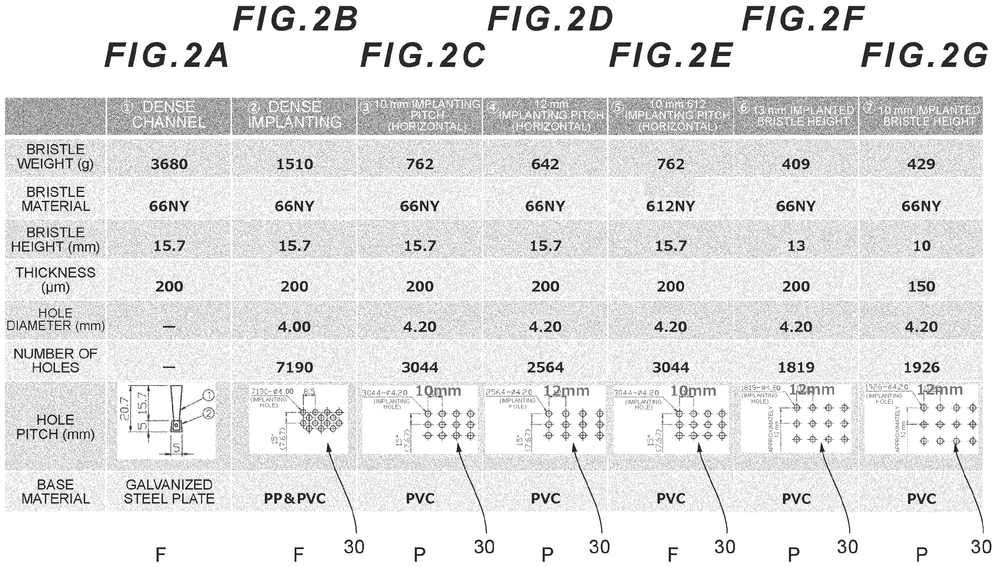

The present inventors manufactured various implanted roll brushes 10 in order to decrease the debris adhering to the implanted roll brush 10 in the cleaning step, to remove adhering debris easily, and to sufficiently remove uncured resin and the like without generating chippings, and performed actual cleaning to test the performance and effects of the implanted roll brushes 10. For this test, the following seven types of roll brushes 10, indicated as (A) to (G), were manufactured and tested (see Figure 1 and Figure 2). The "bristle weight" is the total weight of the bristle bundle 40, "bristle height" is the height (length) from the surface of the brush base 20 to the tip of the bristle bundle 40, "thickness" is a diameter of the bristle, "hole diameter" is an inner diameter of the implanting hole 30, "number of holes" is a total number of implanting holes 30, and "hole pitch" is a distance between the centers of adjacent implanting holes 30.

The outer diameter of the brush 10, including the bristle height, is unified to 90 mm, and the difference in bristle heights is adjusted by changing the outer diameter of the brush base 20.

### [Specifications of 7 types of implanted roll brushes]

### (A) "Dense channel"

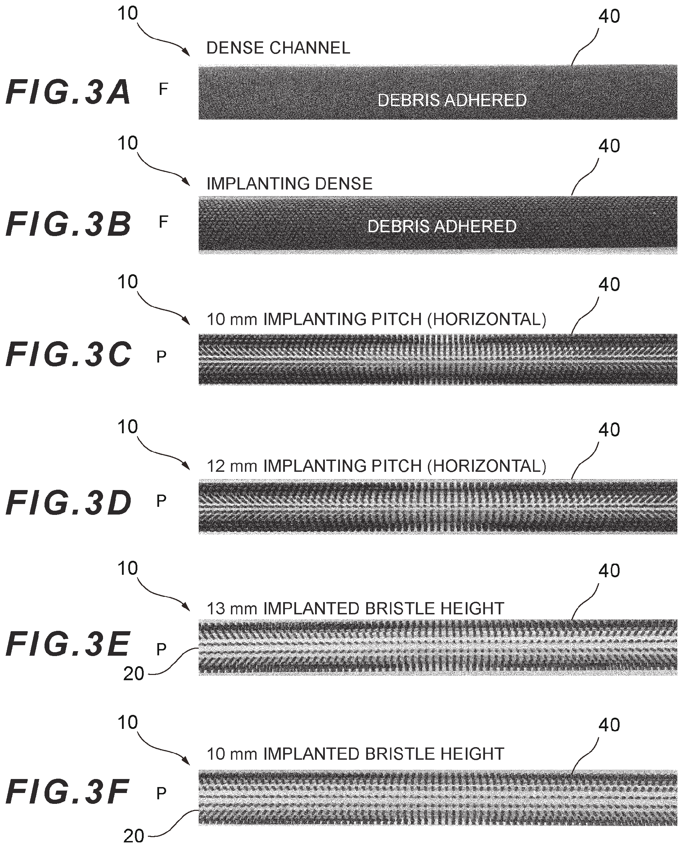

▪ Bristle weight: 3680 (g)
▪ Bristle material: 66 NY
▪ Bristle height: 15.7 (mm)
▪ Thickness: 200 (µm)
▪ Hole diameter (none)
▪ Number of holes: (none)
▪ Hole pitch: (none)
▪ Number of holes per m²: (none)
▪ Bristle weight per m²: 15600 (g)
▪ Maximum depth of hole: (none)
▪ Ratio of maximum depth and bristle height: (none)
▪ Ratio of maximum depth and diameter of bristle bundle hole: (none)
▪ Number of bristles per hole: (none)
▪ Material of base: galvanized steel plate
▪ Note: This roll brush 10 of "dense channel" is a channel roll brush where each bristle bundle 40 is fixed by joining helical metal (galvanized) channels together (see Figure 1(A) and Figure 3A). In such a channel roll brush, it often occurs that debris adheres to the metal channels and gradually form a deposit. In this example, this roll brush 10 of "dense channel", which is one currently available product, is also tested for comparison. Because of the configuration where bristle bundles 40 are fixed to helical metal (galvanized) channels, the plurality of implanting holes 30 do not exist, nor are there such items as an inner diameter of the implanting hole 30 and the number of holes.

### (B) "Dense implanting"

▪ Bristle weight: 1510 (g)
▪ Bristle material: 66 NY
▪ Bristle height: 15.7 (mm)
▪ Thickness: 200 (µm)
▪ Hole diameter: 4.00 (mm)
▪ Number of holes: 7190
▪ Hole pitch: pitch in shaft direction along rotation shaft 20A (hereafter also called "horizontal hole pitch" is 8.5 (mm), and pitch in rotating direction of the rotation shaft 20A (hereafter also called "rotating direction hole pitch") is 7.67 (mm)
▪ Arrangement: zigzag type
▪ Number of holes per m²: 30677
▪ Bristle weight per m²: 6401 (g)
▪ Maximum depth of hole: 10 (mm)
▪ Ratio of maximum depth and bristle height: 10 to 15.7
▪ Ratio of maximum depth and diameter of bristle bundle hole: 10 to 4.0
▪ Number of bristles per hole: 280
▪ Material of base: PP and PVC

### (C) "10 mm implanting pitch (horizontal)"

▪ Bristle weight: 762 (g)
▪ Bristle material: 66 NY
▪ Bristle height: 15.7 (mm)
▪ Thickness: 200 (µm)
▪ Hole diameter: 4.2 (mm)
▪ Number of holes: 3044
▪ Horizontal hole pitch: 10 (mm)
▪ Rotating direction hole pitch: 7.67 (mm)
▪ Arrangement: parallel type
▪ Number of holes per m²: 13038
▪ Bristle weight per m²: 2092 (g)
▪ Maximum depth of hole: 10 (mm)
▪ Ratio of maximum depth and bristle height: 10 to 15.7
▪ Ratio of maximum depth and diameter of bundle hole: 10 to 4.2
▪ Number of bristles per hole: 340
▪ Material of base: PVC

### (D) "12 mm implanting pitch (horizontal)"

▪ Bristle weight: 642 (g)
▪ Bristle material: 66 NY
▪ Bristle height: 15.7 (mm)
▪ Thickness: 200 (µm)
▪ Hole diameter: 4.2 (mm)
▪ Number of holes: 2564
▪ Horizontal hole pitch: 12 (mm)
▪ Rotating direction hole pitch: 7.67 (mm)
▪ Arrangement: parallel type
▪ Number of holes per m²: 10865
▪ Bristle weight per m²: 1762 (g)
▪ Maximum depth of hole: 10 (mm)
▪ Ratio of maximum depth and bristle height: 10 to 15.7
▪ Ratio of maximum depth and diameter of bristle bundle hole: 10 to 4.2
▪ Number of bristles per hole: 340
▪ Material of base: PVC

### (E) "12 mm 612 implanting pitch (horizontal)"

▪ Bristle weight: 762 (g)
▪ Bristle material: 612 NY
▪ Bristle height: 15.7 (mm)
▪ Thickness: 200 (µm)
▪ Hole diameter: 4.2 (mm)
▪ Number of holes: 3044
▪ Horizontal hole pitch: 12 (mm)
▪ Rotating direction hole pitch: 7.67 (mm)
▪ Arrangement: parallel type
▪ Number of holes per m²: 10865
▪ Bristle weight per m²: 1762 (g)
▪ Maximum depth of hole: 10 (mm)
▪ Ratio of maximum depth and bristle height: 10 to 15.7
▪ Ratio of maximum depth and diameter of bristle bundle hole: 10 to 4.2
▪ Number of bristles per hole: 340
▪ Material of base: PVC

### (F) "13 mm implanted bristle height"

▪ Bristle weight: 409 (g)
▪ Bristle material: 66 NY
▪ Bristle height: 13 (mm)
▪ Thickness: 200 (µm)
▪ Hole diameter: 4.2 (mm)
▪ Number of holes: 1819
▪ Horizontal hole pitch: 12 (mm)
▪ Rotating direction hole pitch: 11.82 (mm)
▪ Arrangement: parallel type
▪ Number of holes per m²: 7062
▪ Bristle weight per m²: 948 (g)
▪ Maximum depth of hole: 10 (mm)
▪ Ratio of maximum depth and bristle height: 10 to 13.0
▪ Ratio of maximum depth and diameter of bristle bundle hole: 10 to 4.2
▪ Number of bristles per hole: 340
▪ Material of base: PVC

### (G) "10 mm implanted bristle height"

▪ Bristle weight: 429 (g)
▪ Bristle material: 66 NY
▪ Bristle height: 10 (mm)
▪ Thickness: 150 (µm)
▪ Hole diameter: 4.2 (mm)
▪ Number of holes: 1926
▪ Horizontal hole pitch: 12 (mm)
▪ Rotating direction hole pitch: 12 (mm)
▪ Arrangement: parallel type
▪ Number of holes per m²: 6836
▪ Bristle weight per m²: 706 (g)
▪ Maximum depth of hole: 10 (mm)
▪ Ratio of maximum depth and bristle height: 10 to 10
▪ Ratio of maximum depth and diameter of bristle bundle hole: 10 to 4.2
▪ Number of bristles per hole: 506
▪ Material of base: PVC

### [Roll brush after cleaning test]

For reference, the image after each roll brush 10 of (A) to (G) after the cleaning tests is indicated in Figure 3 (see Figure 3A to Figure 3G).

### [Data on developing performance]

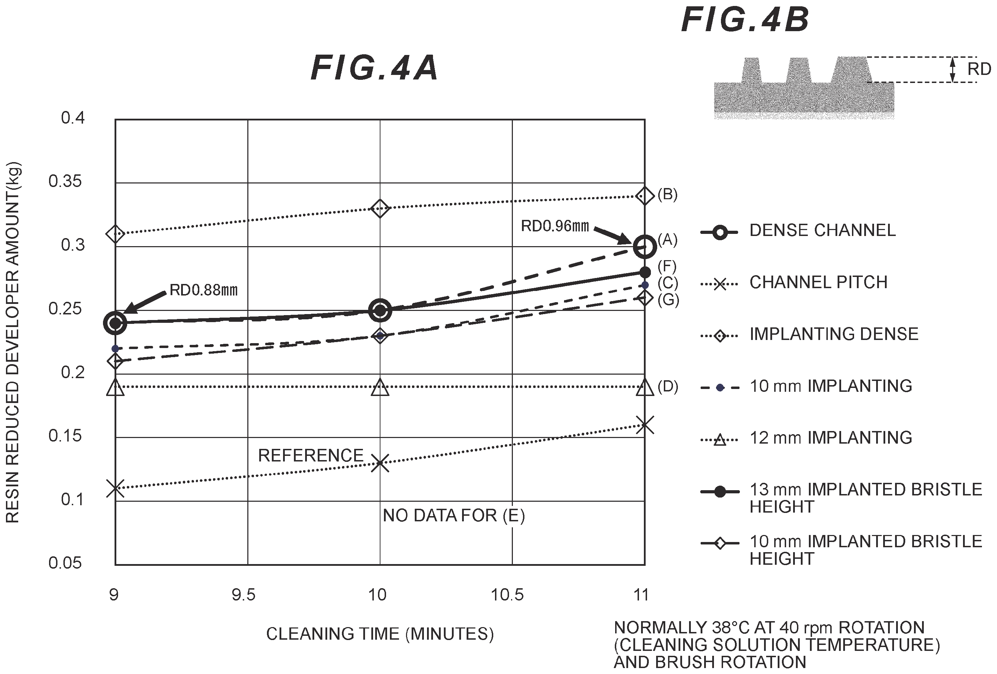

A change of resin developing amount (g) by the roll brushes 10 of (A) to (G) during cleaning time 9 to 11 (minutes) were checked (see Figure 4). The cleaning test was performed under the following environment: cleaning solution temperature: 38°C, rotating speed: 10.2 rpm, oscillating speed: 48 rpm ("oscillating rotation" in present description refers to the rotation of a cam shaft rotating once by one linear reciprocating oscillating motion), contact pressure of brush to printing plate: 180 g/cm2 at the maximum in the case of (C), and 600 g/cm2 at the maximum in the case of (F), and concentration of surface active agent in cleaning solution: 2.1 wt%.

For the implanted roll brush 10 of (E), a "12 mm 612 implanting pitch (horizontal)", opening of bristle bundles 40 is so large that the verification result was not obtained.

### [Verification 1: depth of white line]

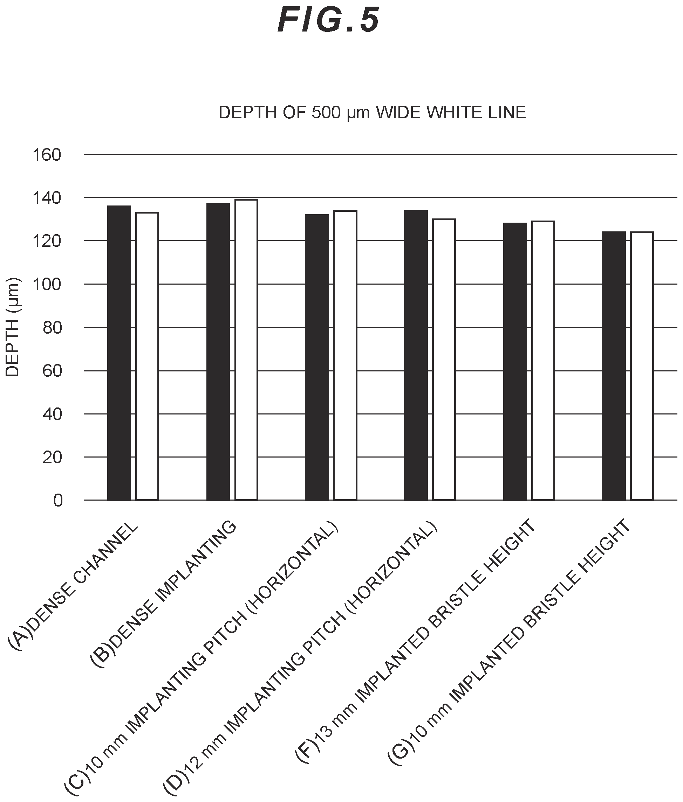

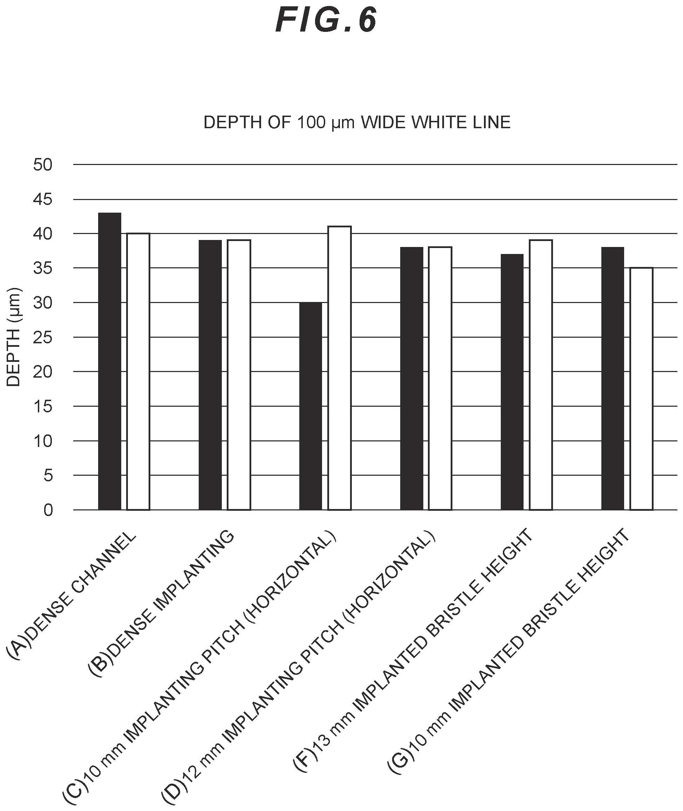

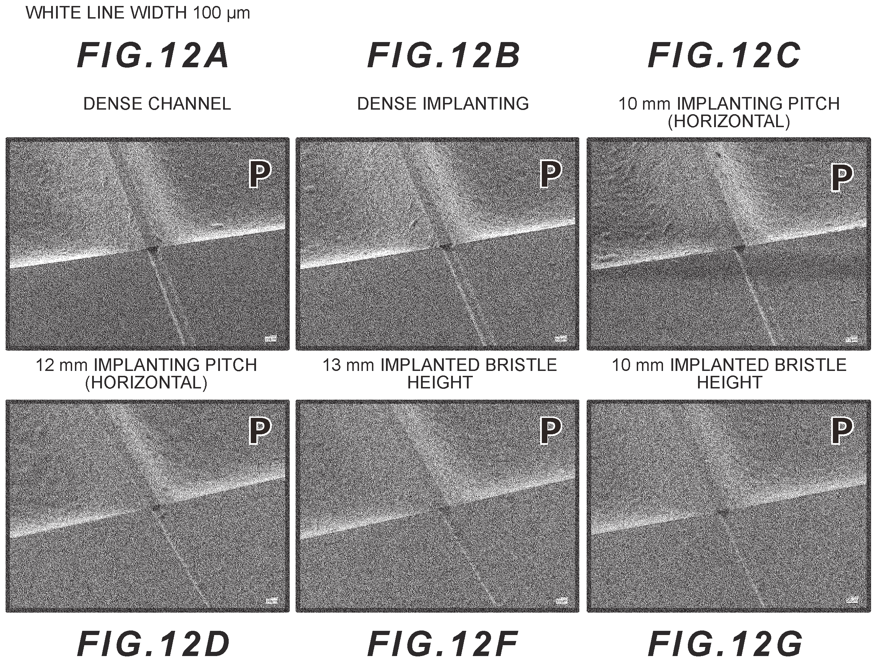

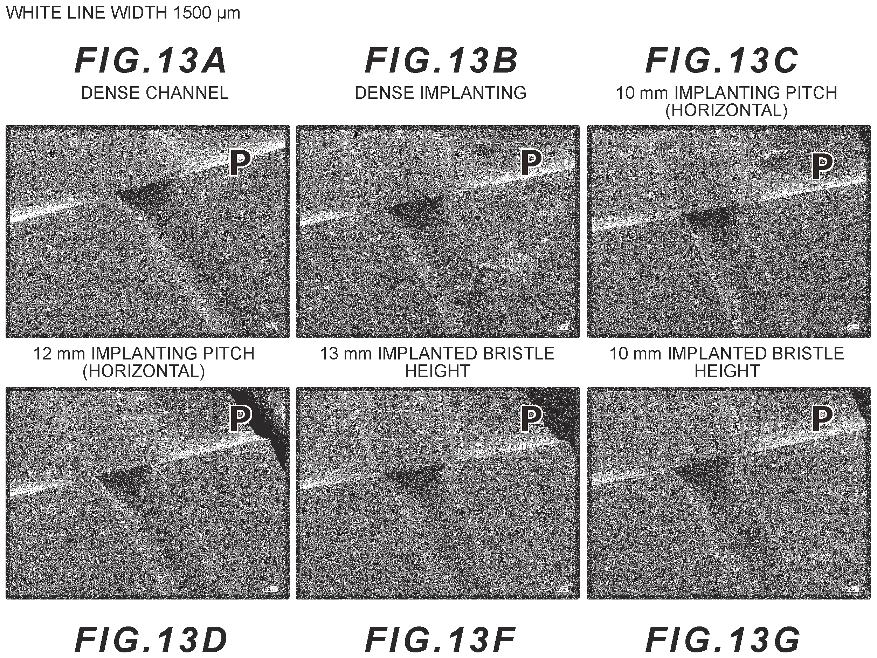

As one index to evaluate the cleaning performance when uncured resin and the like are washed away after exposing the photosensitive resin plate by ultraviolet rays, the depth after cleaning was checked in the case where the concave portion (also called "white line" in present description) of the photosensitive resin plate is 100 µm wide and 500 µm wide (see Figure 5 and Figure 6). The depth was 35 µm or more in the case of a 100 µm width, and 120 µm or more in the case of a 500 µm width, and the quality problem was not observed in the actual printing test, hence it was determined that cleaning performance was good. In this test, the center portion and a portion closer to the side (right side in Figure 7) of the cleaning apparatus 100 were checked respectively. The results were good for all of A "dense channel", B "dense implanting", C "10 mm implanting pitch (horizontal)", D "12 mm implanting pitch (horizontal)", F "13 mm implanted bristle height" and G "10 mm implanted bristle height" in Figure 12 and Figure 13 (see Figure 12 and Figure 13). The reference sign P in the drawings indicates that the result was good.

### [Verification 2: chipping (1)]

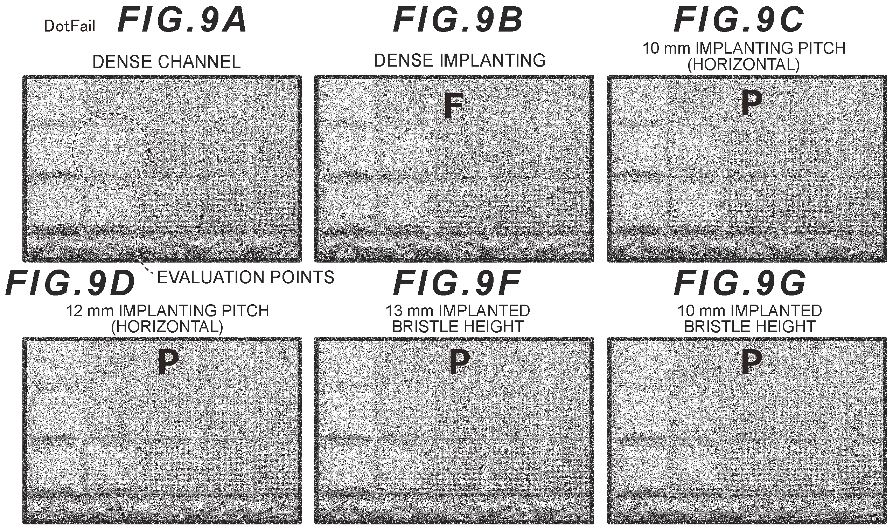

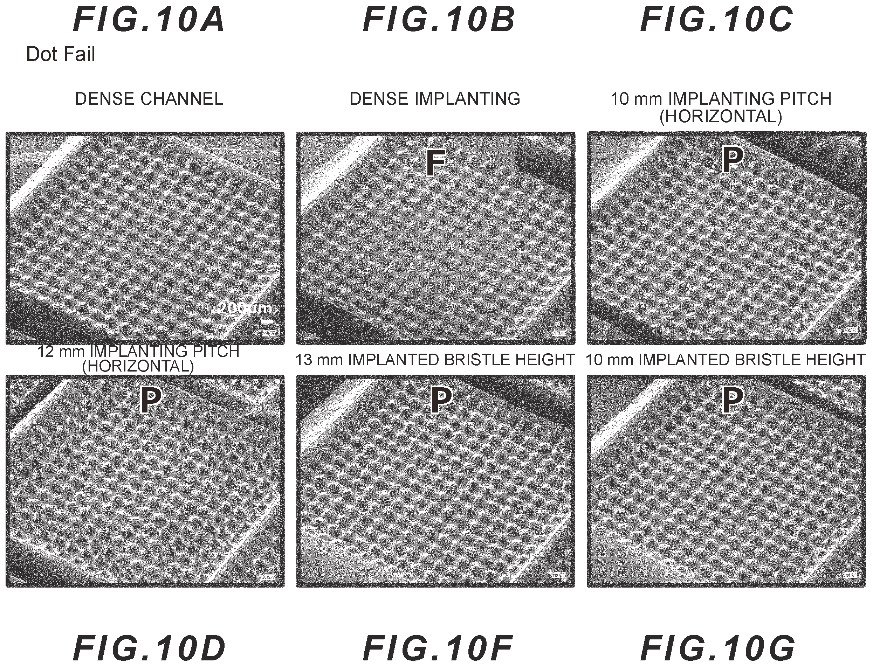

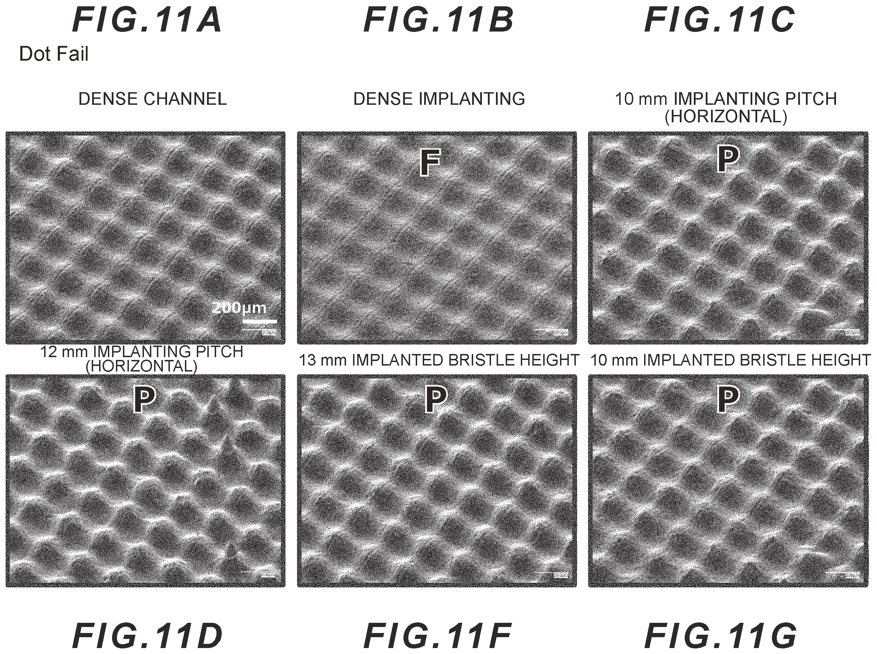

It was evaluated whether chipping was generated in the photosensitive resin plate after cleaning. The results were that: B "dense implanting" was not good since chipping was generated, but otherwise was good for all of C "10 mm implanting pitch (horizontal)", D "12 mm implanting pitch (horizontal)", F "13 mm implanted bristle height", and G "10 mm implanted bristle height" in Figure 9, Figure 10 and Figure 11 (see Figure 9, Figure 10 and Figure 11).

### [Verification 3: chipping (2)]

It was evaluated whether chipping was generated in the photosensitive resin plate after cleaning under the condition "Dot Fail" (see Figure 9 to Figure 11). The evaluation points here are predetermined positions of the photosensitive resin plate (The reference sign P in the drawings indicates that the result was good.

### [Verification 4: performance of cleaning printing plate (3)]

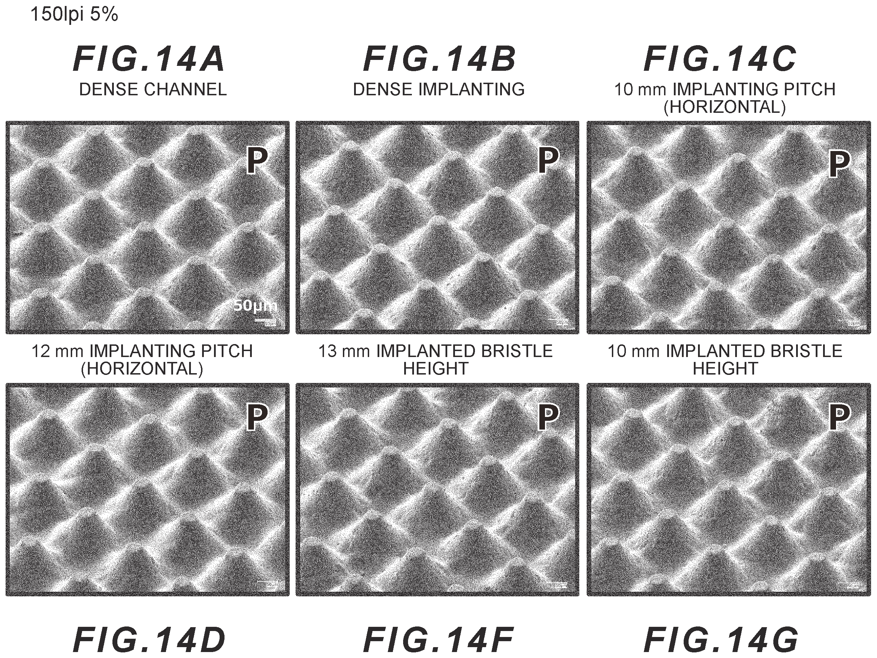

It was evaluated whether uncured resin at fine portions in the photosensitive resin plate was removed after cleaning under the following conditions: 150 Ipi and 5%. The evaluation points here are on the side portion of the photosensitive resin plate. The results were good for all of Figure 14A "dense channel", Figure 14B "dense implanting", Figure 14C "10 mm implanting pitch (horizontal)", Figure 14D "12 mm implanting pitch (horizontal)", Figure 14 F "13 mm implanted bristle height", and Figure 14G "10 mm implanted bristle height" (see Figure 14). The reference sign P in the drawings indicates that the result was good.

### [Verification 5: performance of cleaning printing plate (4)]

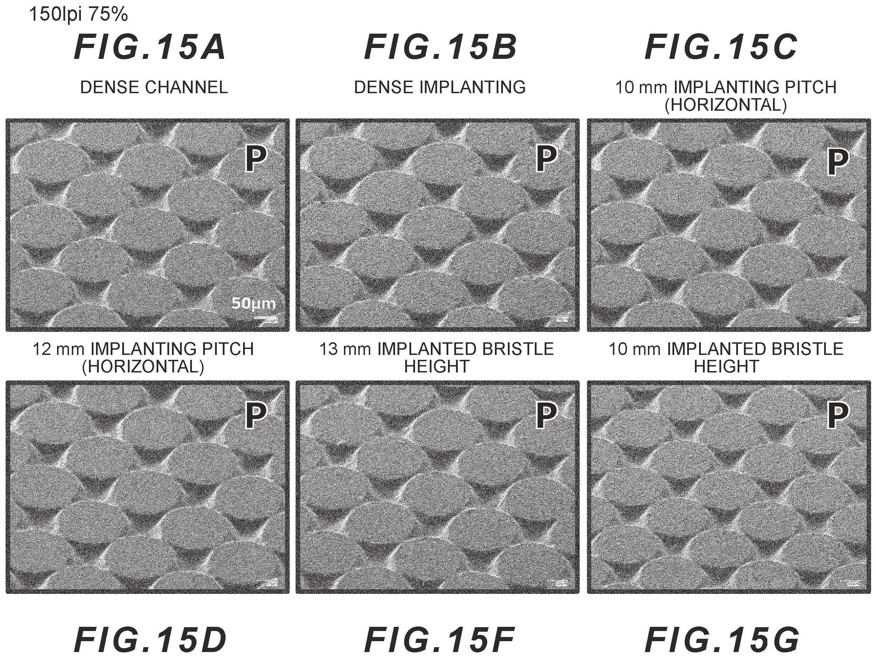

It was evaluated whether uncured resin at fine portions in the photosensitive resin plate was removed after cleaning under the following conditions: 150 Ipi and 75%. The evaluation points here are on the side portion of the photosensitive resin plate. The results were good for all of Figure 15A "dense channel", Figure 15 B "dense implanting", Figure 15C "10 mm implanting pitch (horizontal)", Figure 15D "12 mm implanting pitch (horizontal)", Figure 15F "13 mm implanted bristle height", and Figure 15G "10 mm implanted bristle height" (see Figure 15). The symbol P in the drawings indicates that the result was good.

### [Verification result]

As a result of repeating various examinations, test and verifications described above, it was discovered that in the implanted roll brush 10 of which brush base 20 is formed of resin, various factors, such as implanting density, bristle height, thickness of bristles, implanting holes, and in particular such factor as density of the implanted bundle pitch of the bristle bundle 40, influence the adhesion of debris, removal of debris, the chipping resistance, and the like. It was also discovered that the adhesion of debris, removal of debris and chipping resistance are improved or good performance is maintained if the bristle height of the bristle bundle 40 is set within a predetermined range, and density of the bristles implanted in the implanting hole 30 is kept within a predetermined range. Based on this knowledge, the following are the preferable ranges of the bristle height of the bristle bundle 40 and the like.

### [Preferable range (1)]

The bristle height of the bristle bundle 40 is preferably 8 mm or more and 20 mm or less, and a number of implanting holes 30 is preferably 4000/m2 or more and 15000/m2 or less. The bristle height of the bristle bundle 40 is more preferably 10 mm or more and 18 mm or less, and is even more preferably 12 mm or more and 15 mm or less. An optimum value of the bristle height of the bristle bundle 40 is 13 mm.

### [Preferable range (2)]

A number of implanting holes 30 is preferably6000/m2 or more and 9000/m2 or less and is more preferably 6500/m2 or more and 8000/m2 or less, An optimum value of a number of implanting holes 30 is 7062/m2 or less.

### [Preferable range (3)]

The bristle diameter of each bristle of the bristle bundle 40 is preferable 80 µm or more and 400 µm or less, is more preferably 100 µm or more and 300 µm or less, and is even more preferably 170 µm or more and 230 µm or less.

### [Preferable range (4)]

The bristle amount of the bristle bundle 40 is preferable from 500 g/m2 to 4000 g/m2, is more preferably from 700 g/m2 to 2000 g/m2, and is even more preferably from 800 g/m2 to 1200 g/m2. An optimum value of the bristle amount of the bristle bundle 40 is 948 g/m2. The bristle amount (weight of bristles) in the present description refers to the weight of all the bristles of the bristle bundle 40, including the portions implanted inside the implanting hole 30. The metal fittings used for fixing the bristle bundle 40 is not included in this weight. If the bristle amount of the bristle bundle 40 of the implanted roll brush 10 is in the above mentioned preferable range, debris adheres less to the implanted roll brush 10, and the adhering debris can be easily removed, hence cleaning performance of the printing plate improves. This implanted roll brush 10 has less bristle density than the commonly used brushes for development, that is, the developer easily passes through.

### [Preferable range (5)]

The hole diameter of the implanting hole 30 is preferably 1.0 mm or more and 6.0 mm or less, and a number of bristles is preferably 100/hole or more and 500/hole or less. The hole diameter of the implanting hole 30 is preferably 3.0 mm or more and 5.0 mm or less, and is more preferably 4.0 mm or more and 4.5 mm or less. A number of bristles is preferably 200/hole or more and 400/hole or less, is more preferably 310/hole or more and 370/hole or less, is even more preferably 320/hole or more and 360/hole or less, and is most preferably 330/hole or more and to 350/hole or less. An optimum value of the number of bristles is 340/hole. A number of bristles is a number of bristles protruding from an implanting hole 30. If a number of bristles is 340/hole, for example, a total of 170 bristles are used since one bristle is bent in half. A conclusion obtained is that if an implanted roll brush 10, of which hole diameter of the implanting hole 30 or a number of bristles is in the above mentioned preferable range, is used, bristles hardly come off during cleaning, and high performance of cleaning the printing plate can be maintained for a long period of time. Another conclusion obtained is that in the implanted roll brush 10, a ratio of a depth of the implanting hole 30 and bristle height is preferably 10:13, and a ratio of a depth of the hole and the hole diameter is preferably 10:4.2. The holes were opened using a drill of which point angle is 140°, and a digital caliper CD-10 APX (point diameter: 1.9 mm) made by Mitsutoyo Corp. was used. The maximum depth of the implanting hole is preferably 5 mm or more and 20 mm or less, is more preferably 8 mm or more and 15 mm or less, and is even more preferably 9 mm or more and 13 mm or less. If the maximum depth of the implanting hole is in this preferable range, the bristles are less likely to open up, and the cross section of the bristle bundle tip becomes a shape closer to a perfect circle, hence stable cleaning can be maintained.

### [Preferable materials]

It was discovered that a material of the brush base 20, except for (A), is preferably PVC or PP and a material for the bristles is preferably one of 66 NY, 612 MY, 610 NY, PP and ABS. In this case, the implanted roll brush 10 can be easily processed during manufacturing.

It was confirmed that use of the implanted roll brush 10 of Example (1) dramatically decrease the adhesion of debris, (2) removes adhering debris easily, which improves operability, (3) implements developing performance (performance during cleaning) equivalent to that of conventional products, (4) improves chipping resistance, (5) decreases load on developing apparatus, and (6) allows configuring the implemented roll brush 10 together with a resin brush base 20 and a stainless shaft separately at low cost (reducing environment load).

### [Shape of tip of bristle]

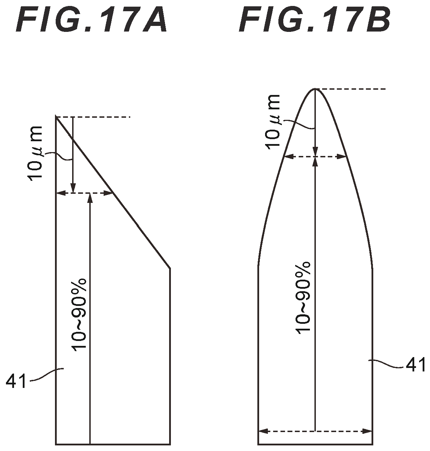

The tip of a bristle of the implanted roll brush 10 (indicated by reference number 41 in Figure 17) is pointed, and the width at a 10 µm position from the top toward the root is preferably from 10% to 50% with respect to the width of the root of the bristle, is more preferably 20% or more and 50% or less, and is even more preferably 30% to 50%. Then the bristle tips can enter fine recessed portions (e.g. 50 µm grooves), which improves the cleaning performance, removes uncured resins, and gently develops spaces between narrow dot pitches (see Figure 17).

### [Plate making method]

In the developing step of the method for making the printing plate, which includes the exposing, developing and rinsing steps, the implanted roll brush 10 used for brushing the plate surface preferably has a bristle heigh of 8 mm or more and 20 mm or less, and a number of implanting holes 30 of 4000/m2 or more and 15000/m2 or less. The bristle height is more preferably 10 mm to 18 mm, and is even more preferably 12 mm to 15 mm. An optimum value thereof is 13 mm. The number of implanting holes 30 is preferably 6000 to 9000/m2, and is more preferably 6500 to 8000/m2.

Needless to say, the various implanted roll brushes 10 described thus far in each embodiment may be combined and used for the method for making a printing plate, which includes the exposing, developing and rinsing steps. After the rinsing step, a draining step may be performed.

The above mentioned embodiments are preferred examples of the present invention, but the present invention is not limited to these, and may be modified in various ways within a scope not departing from the spirit of the present invention. For example, the arrangement of the implanting holes 30 of the implanted roll brush 10 may be selected as required from a parallel type, a zigzag type, a V-shaped type, a spiral type, and the like (see Figure 16).

The rotating speed of the implanted roll brush 10 during cleaning is preferably3 rpm or more and 25 rpm or less. The oscillating speed during oscillating rotation (rotation of the cam shaft, which rotates once by a linear reciprocating oscillating motion), is preferably 20 rpm or more and 150 rpm or less. The rotating speed is more preferably 7 to 18 rpm, and is even more preferably 9 to 15 rpm. At these speeds, cleaning solution is held well in the implanted roll brush 10, and therefore the implanted roll brush 10 is less likely to become dirty. The rotating direction, timing when oscillation shifts, and speed of each implanted roll brush 10 may be the same or different. The rotating speed may be the same or may vary. For example, the speed may be initially fast to increase productivity, may slightly slow in mid-stage to decrease load on the protruding portions on the printing plate, and may further slow down in the final stage so that the bristle tips can enter the recessed portions in the printing plate, and unexposed resin can be sufficiently removed.

In the developing step, the contact pressure of the implanted roll brush 10 to the printing plate is preferably 50 g/cm2 or more and 800 g/cm2 or less at the maximum, is more preferably 300 to 800 g/cm2, and is even more preferably 500 to 800 g/cm2. In this range, developing time can be decreased in a range without affecting the quality of the printing plate. The contact pressure of the implanted roll brush 10 can be adjusted by a bristle height, a number of holes of the implanting holes 30, a bristle diameter, a bristle amount, a hole diameter of the implanting hole 30, a bristle density, a rotating speed of the implanted roll brush 10, an oscillating speed, and the like. To measure the contact pressure, I-SCAN (a pressure distribution measuring system) made by Nitta Corp. was used.

The tip of the bristle of the implanted roll brush 10 is spherical, and an R thereof is preferably 50 µm or more and 230 µm or less, is more preferably 70 to 200 µm, and is even more preferably 100 to 180 µm. Thereby cured photosensitive resin (which should not be scraped off) can be protected from scratching.

It is preferable to use an implanted roll brush 10 of which shape of the tip of the bristle is as mentioned above. In other words, the tip of the bristle of the implanted roll brush 10 (indicated by reference number 41 in Figure 17) is pointed, and the width at a 10 µm position from the tip toward the root is preferably from 10% to 50% with respect to the width of the root of the bristle, is more preferably 20% or more and 50% or less, and is even more preferably 30% to 50%. Then the bristle ends can enter fine recessed portions (e.g. 50 µm grooves), which improves the cleaning performance, removes uncured resin, and gently develops spaces between narrow dot pitches (see Figure 17).

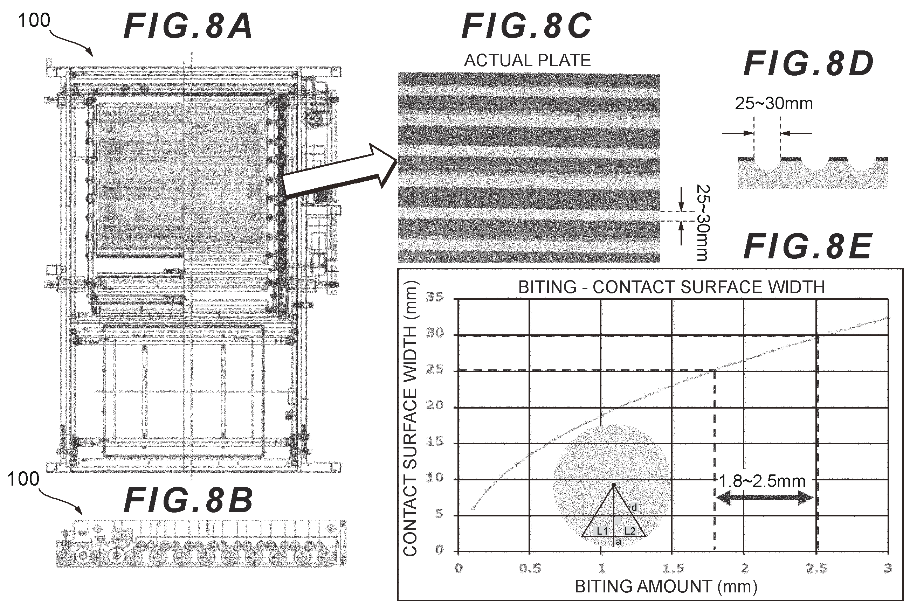

A biting amount of the brush to the printing plate is preferably 1 mm to 5 mm, is more preferably 2 mm or more and 5 mm or less, and is even more preferably 2 mm to 4 mm. This applies load on the brush, delays deterioration of the bristles of the brush, and maintains high cleaning performance (see Figure 8.)

This also reduces an area that is in contact with the printing plate, and prevents such a problem as a plate attached to a conveying table from coming off.

It is preferable that the developer used in a developing step contains a surface active agent of which content percentage is 0.2 wt% or more and 9.0 wt% or less. In this case, both high developing performance and foaming suppression can be implemented, and the implanted roll brush 10 can be cleaned while performing development. If flow rate of the cleaning solution is increased to supply a large amount of developer to the implanted roll brush 10, the implanted roll brush 10 becomes less dirty, and a number of times of cleaning the implanted roll brush 10 can be decreased.

Compared with the "dense channel" brush, the implanted roll brush 10 of the present embodiment has a wide pitch between bristle bundles and less amount of bristles, hence fluidity of the cleaning solution on the table (1.2° inclination) can be improved, and the thickness of the printing plate can be uniform. Therefore the cleaning time can be shortened, and quality control becomes easier.

The channel brush has a narrow pitch between bristle bundles, and a large amount of bristles, hence fluidity of the cleaning solution is not good, and cleaning performance on the upper side (higher side) of the inclined table is poor. In a case where the hole pitch is 12 mm, it was confirmed that the fluidity of the cleaning solution is particularly good, while cleaning time is equivalent to a conventional brush. In the case of a conventional brush, thickness variation within the plate surface is large, since bristle amount is high and fluidity of the cleaning solution is not good (plate thickness tends to be thick on the upstream side of the inclined table, and thin on the downstream side).

This implanted brush is also applicable to a drum type apparatus, a batch type apparatus, and an inline apparatus.

### <<Example 2>>

Using the above mentioned roll brush (D) (12 mm implanting pitch (horizontal), the present inventors checked the relationship between: (i) the roll rotating speed, (ii) the brush contact pressure, and (iii) the brush biting amount; and A: cleaning speed and B: chipping resistance, and determined preferable ranges in which the quality of the printing plate can be improved.

Here a cleaning test was performed under an ordinary environmental range of: cleaning solution temperature: 38°C, oscillating speed: 48 rpm, and concentration of surface active agent in cleaning solution: 2.1 wt%. The photosensitive resin plate used here has a thickness of 1.14 mm and a size of 900 mm × 1200 mm.

Scores were determined by evaluating the content indicated in Table 1 below.

**[Table 1]**

| SCORE | DEVELOPING PERFORMANCE | CHIPPING RESISTANCE |
|---|---|---|
| 1 | 20% OR LESS | 50% OR **MORE** |
| 2 | 20~40% | 30~50% |
| 3 | 40~60% | 10-30% |
| 4 | 60~80% | 10% OR LESS |
| 5 | 80% OR MORE | NONE |

In the cleaning performance of the 1.14 mm plate used for the test, 100% is when 0.9 mm can be cleaned on average at 25 points on the surface.
Example) If 0.5 mm cleaning is possible on average at 25 points, the cleaning performance is 55.6%, and the score is 3
If 0.3 mm cleaning was possible on average at 25 points, the cleaning performance is 33.3%, and the score is 2
The chipping resistance was observed for 15% of 150 Ipi, and a 10 mm × 10 mm area was evaluated.
Example) If 35% of chipping is generated in an area, out of 10 mm × 10 mm = 100 mm², the score is 2
If 55% of chipping is generated in an area, out of 10 mm × 10 mm = 100 mm², the score is 1

### (i) Roll rotating speed

Test conditions of the brush rotating speed are as indicated in Table 2, and scores and points were determined for the cleaning performance and chipping resistance based on the content of Table 2.

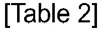

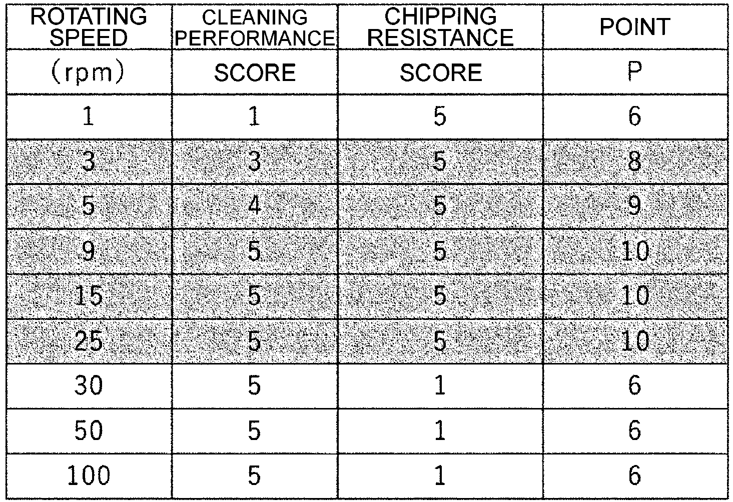

As a result of the test, it was confirmed that a preferable range is 3 to 25 rpm.

### (ii) Brush contact pressure

Test conditions of the brush contact pressure are as indicated in Table 3, and scores and points were determined for the cleaning performance and chipping resistance based on the content of Table 3.

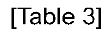

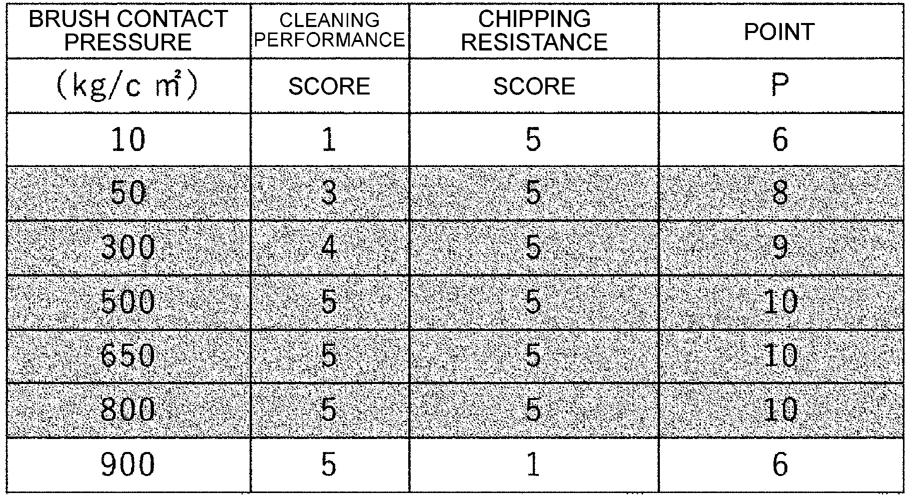

As a result of the test, it was confirmed that a preferable range is 50 to 800 kg/cm².

### (iii) Brush biting amount

Test conditions of the brush biting amount are as indicated in Table 4, and scores and points were determined for the cleaning performance and chipping resistance based on the content of Table 4.

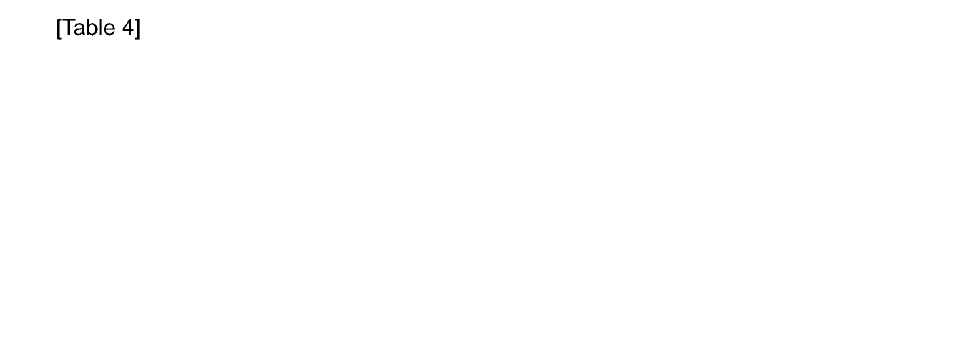

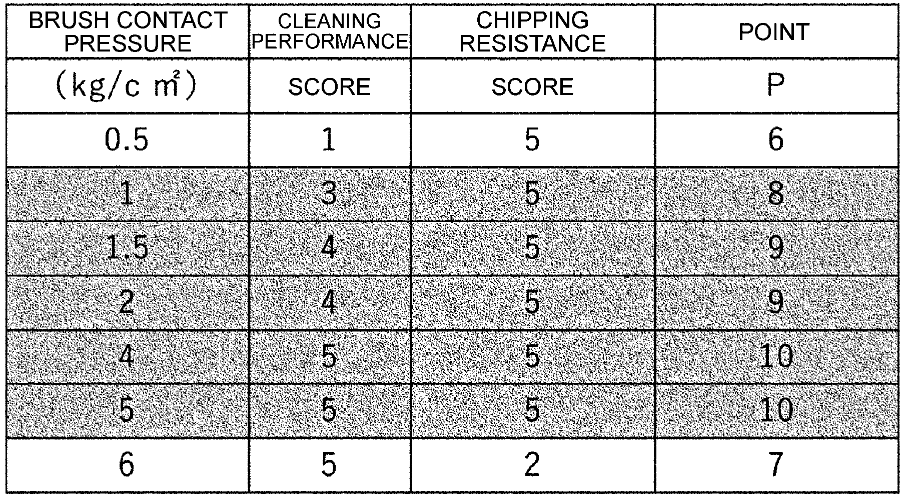

As a result of the test, it was confirmed that a preferable range of the brush biting amount is 1 to 5 mm.

### <<Embodiment 2 of Invention>>

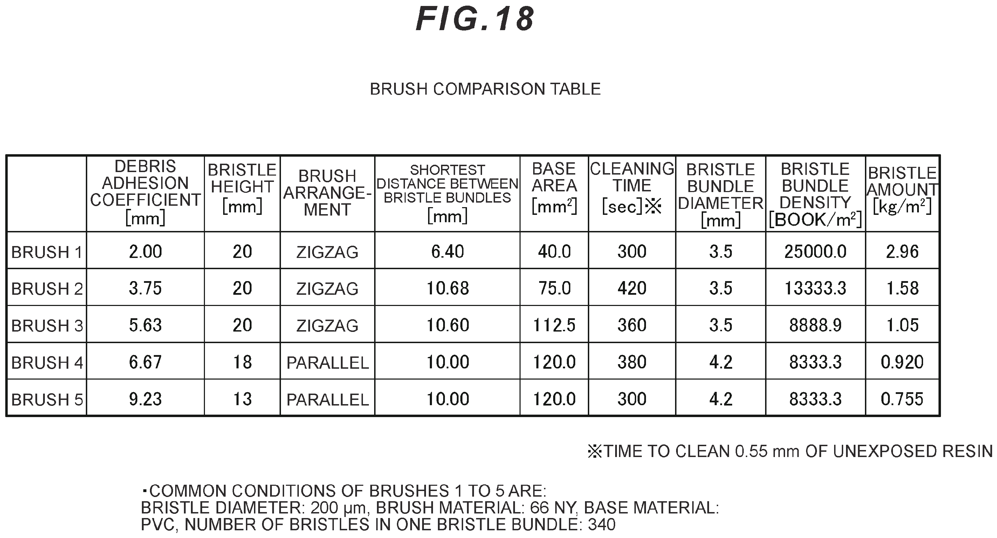

The configuration of the present invention will be described in detail with reference to an example of Embodiment 2 indicated in the drawings (see Figure 18 and the like). In the following, an implanted flat brush 50 and a method for manufacturing a printing plate using this brush will be described first, then a printing plate developing step system 300 will be described.

### [Implanted flat brush]

In various steps to make a printing plate, the implanted flat brush 50 is used in a cleaning step in which uncured resin and the like (unexposed portions) are washed away and removed while applying water-based developer. The various steps to make a printing plate may include only an exposing step and a developing step, or may further include a rinsing step.

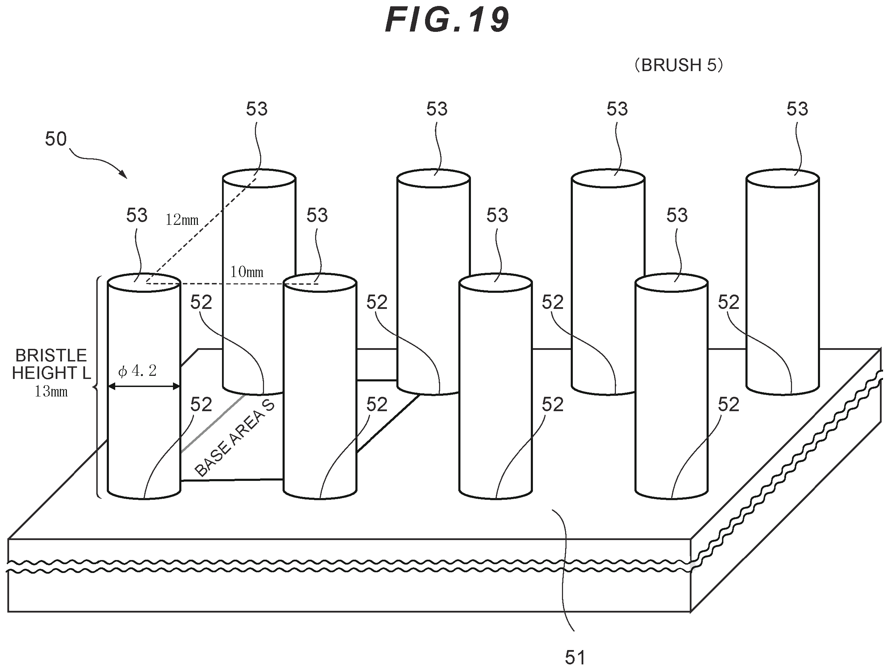

The implanted flat brush 50 of Embodiment 2 is configured by implanting bristle bundles 53 into a plurality of implanting holes 52 in a brush base 51 which is formed of resin (see Figure 19). The brush base 51 is a flat plate, and the plurality of implanting holes 52 are formed on one surface side. The bristle bundles 53 are implanted into the plurality of implanting holes 52 at equal intervals. "Equal intervals" here includes not only the case where intervals are exactly the same, but also the case where intervals are substantially the same (approximately equal intervals). For example, the case where the intervals are substantially the same (approximately equal intervals) is a case where an interval of two patterns is alternately set to adjust the bristle bundle density, considering the cleaning performance and debris adhesion, but in general the intervals are approximately the same, or a case where intervals are partially different, for such reasons as arrangement of the cleaning holes 54 or attachment of screws to fix the brush, but in general intervals are approximately the same. An arrangement of the bristle bundles 53 that are implanted in the plurality of implanting holes 52 at equal intervals is, for example: bristle bundles 53 are arranged at equal intervals on a certain line; and bristle bundles 53 are also arranged at equal intervals on a line that is parallel with the above line.

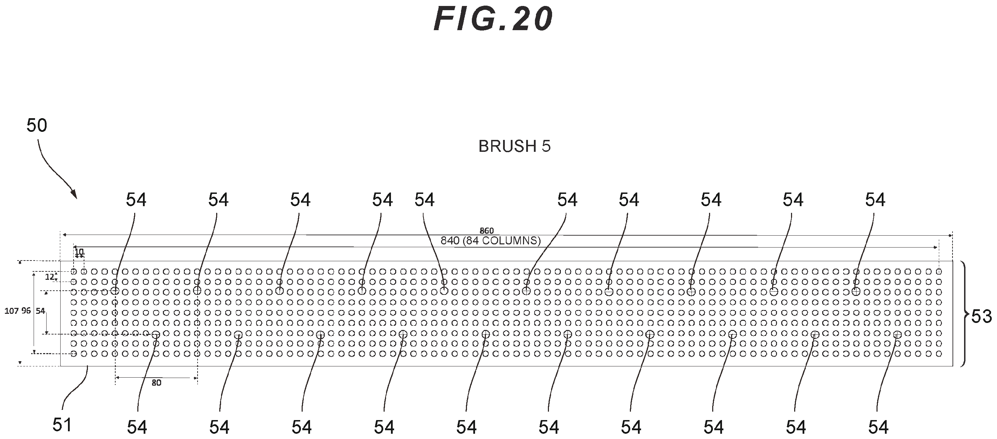

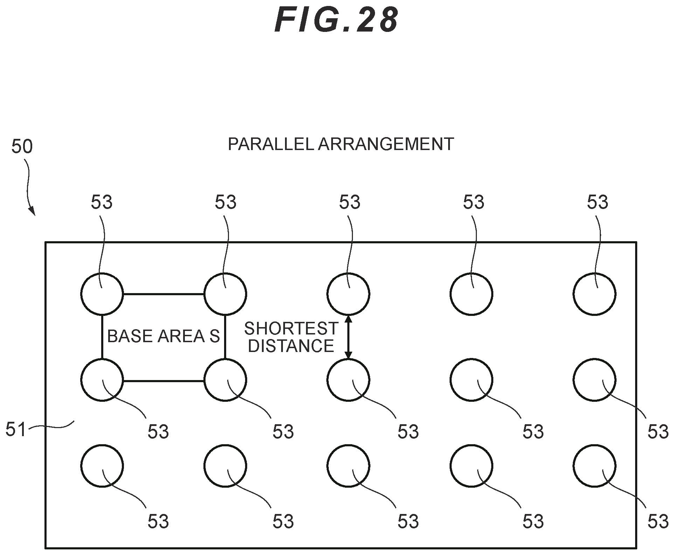

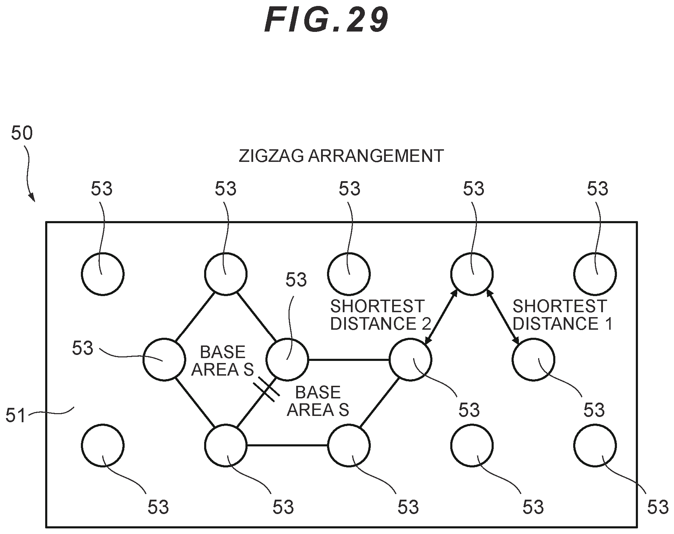

The plurality of bristle bundles 53 may be arranged in a predetermined pattern, such as a parallel arrangement, a zigzag arrangement, a V-shaped arrangement, and a spiral arrangement (see Figure 19, Figure 20 and the like). In the case of "parallel arrangement", the bristle bundles 53 are arranged on a line at equal intervals, and from each bristle bundle 53 on a line, bristle bundles 53 are arranged in the vertical direction at equal intervals (see Figure 28). In the case of "zigzag arrangement", the bristle bundles 53 are arranged on a line at equal intervals, and on a line parallel with this line, bristle bundles 53 are arranged at equal intervals (excluding the case of parallel arrangement). In the zigzag arrangement, positions of the bristle bundles 53 are alternately shifted for each column, for example, such as shifting a half pitch for each column, or positions of the bristle bundles 53 are at holes created at each vertex of an equilateral triangle. The bristle bundles 53 may also be disposed such that a surface area, connecting a center of a bristle bundle 53 and centers of three bristle bundles 53 in close proximity (total of 4 points) become constant (see Figure 29). In the present embodiment, it is assumed that a smallest base area formed by four bristle bundles 53 in close proximity is S [mm2] (hereafter also called "smallest base area"), a bristle height of the bristle bundle 53 is L ([mm] (see Figure 19), and S/L is called "debris adhesion coefficient". The shape of the smallest base area S varies, and, for example, is a rectangle in the case where the bristle bundles 53 are in the parallel arrangement (see Figure 28), and is a parallelogram in the case where the bristle bundles 53 are in the zigzag arrangement (see Figure 29). A side of each base area (shape) here is a line connecting the center points of the implanting holes 52.

### [Printing plate developing step system]

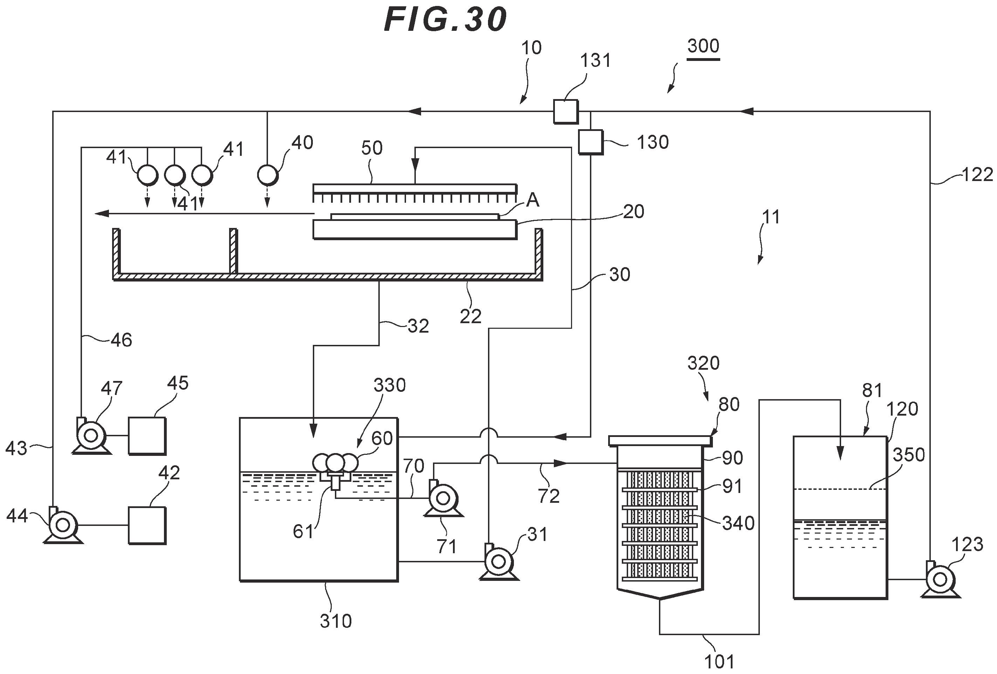

The printing plate developing step system 300 is a system used for a developing step of a printing plate, which is made via various steps, and includes the above mentioned implanted flat brush 50, a developer tank 310, a developer filtering apparatus 320, and the like (see Figure 30). The steps to make the printing plate may include only the exposing step and the developing step, or may further include the rinsing step. The developer filtering apparatus 320 includes at least one filter, such as a dispersoid filter 340 which aggregates dispersoid dispersed in the developer, and an aggregate filter 350 which removes the aggregated substances, aggregated by the dispersoid filter 340. The developer tank 310 includes a developer suction apparatus 330. The developer filtering apparatus 320 filters developer sucked by the developer suction apparatus 330. For more on the configuration of the printing plate developing step system 300, see the description and drawings of Japanese Patent Application No. 2009-17963 (Japanese Patent No. 5503214), for example. The reference signs in Figure 30 are as follows: 10A: developer supplying apparatus, 11: developer processing apparatus, 20: placing table, 22: drain pan, 30A: developer supply pipe, 31: pump, 32: developer discharge pipe, 40: rinse nozzle, 41: rinse brush, 42: developer supply source, 43: developer supply pipe, 44: pump, 45: water supply source, 46: water supply pipe, 47: pump, 60: float member, 61: developer suction member, 70: developer suction pipe, 71: pump, 72: liquid supply pipe, 80: first filter apparatus, 81: second filter apparatus, 90: housing, 91: basket, 92: dispersoid filter, 101: liquid supply pipe, 120: filter tank, 121: aggregate filter, 122: liquid supply pipe, 123: pump, 130: valve, and 131: valve.

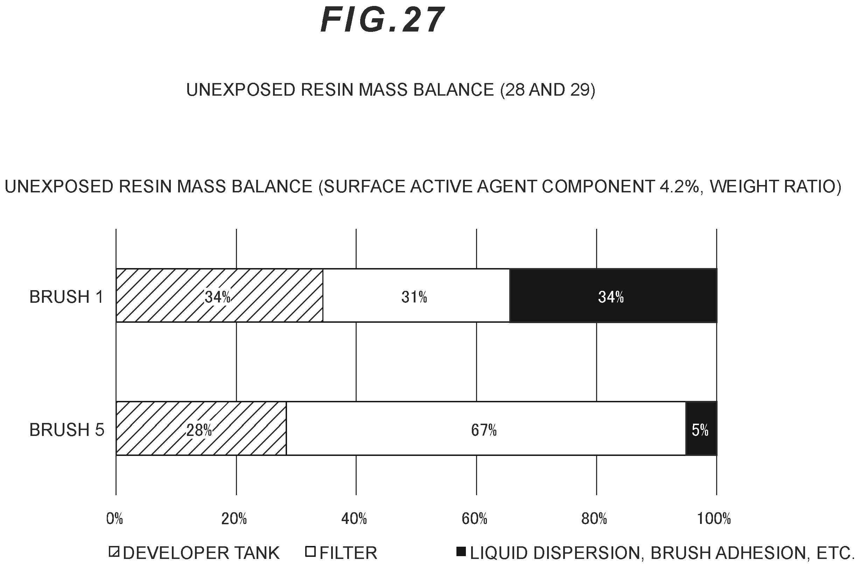

The printing plate developing step system 300 of this embodiment is configured such that as an unexposed resin mass balance in the case where the unexposed resin is supplied into the printing plate developing step system 300, the total of resin existing in the developer filtering apparatus 320 and resin floating in the developer tank 310 is 70.0 wt% or more and 95.0 wt% or less, with respect to the supplied unexposed resin (see Figure 27).

### <<Example 3>>

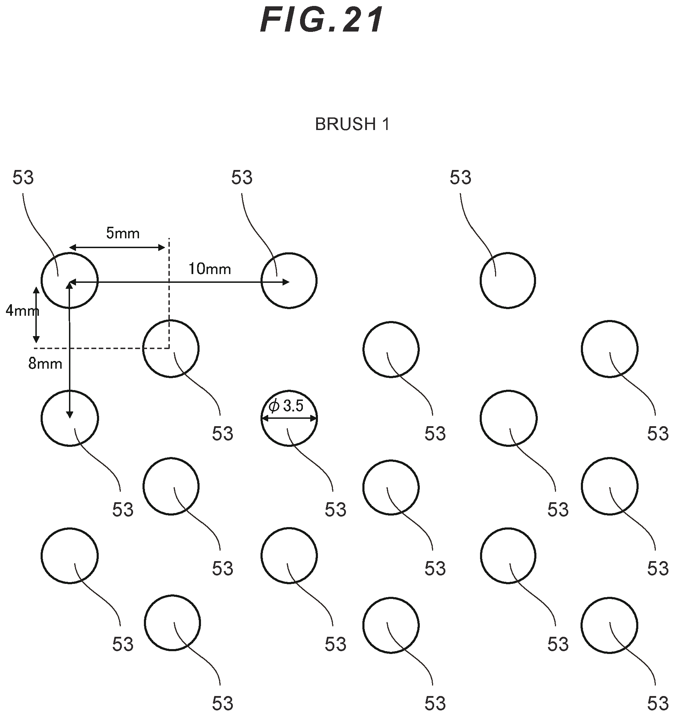

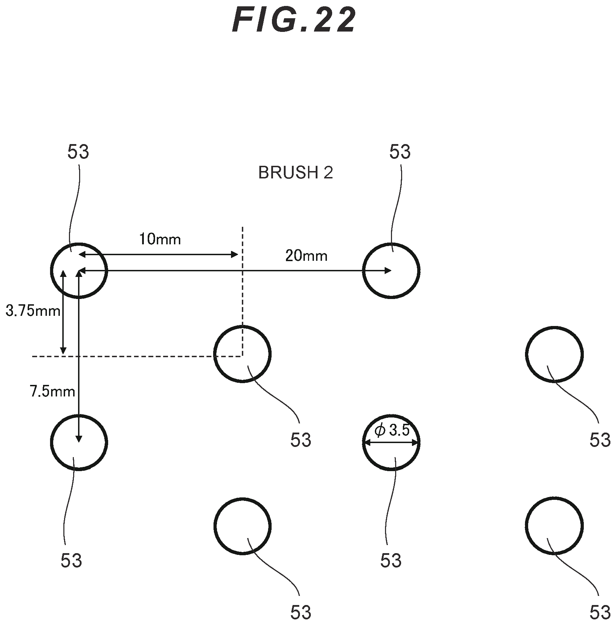

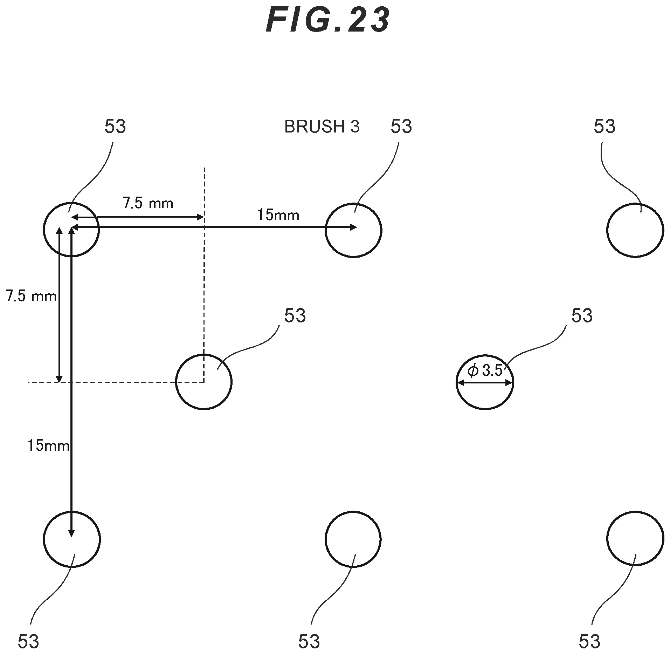

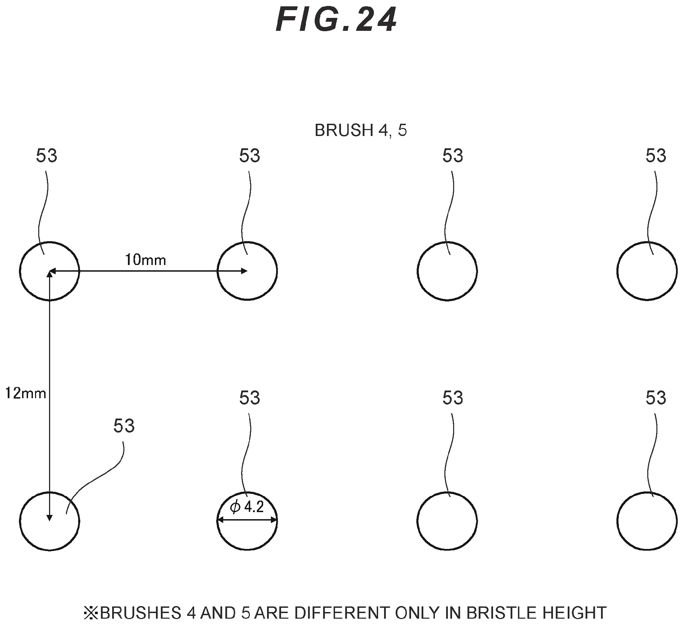

The present inventors manufactured various implanted flat brushes 50 in order to decrease debris adhering to the implanted flat brush 50 in the developing step, to remove adhering debris easily, and to sufficiently remove uncured resin and the like, and performed actual cleaning to test performance and effects (see Figure 18 to Figure 27). For this test, five types of implanted flat brushes 50, which are sequentially called "brush 1", "brush 2", ···, and "brush 5" were manufactured and tested (see Figure 18). These five types of implanted flat brushes 50 are different in terms of various parameters (debris adhesion coefficient (S/L), bristle height [mm], brush arrangement, shortest distance between bristle bundles [mm], cleaning time [sec], bristle bundle diameter [mm], bristle bundle density [/m2], and bristle amount [kg/m2]. The "bristle height" is the height (length) from the surface of the brush base 51 to the tip of the bristle bundle 53. The "cleaning time" is the time to clean the unexposed resin for 0.55 mm. In these five types of implanted flat brushes 50 (brush 1 to brush 5), the diameter of the bristle is 200 µm, the brush material is 66 NY, the base material is PVC, and a number of bristles in one bristle bundle is 340 (see Figure 18).

In this example, the printing plates were manufactured using the printing plate developing step system 300, which includes the abovementioned implanted flat brush 50. For the manufacturing, an implanted flat brush 50 that includes 2 or more types of regions, in which at least one of thickness, length and material of the bristles is different, was used, and an implanted flat brush 50, appropriate for the design and/or quality of the printing plate, was selected. In the developing step, the brush contact pressure was adjusted by inserting a spacer at the root of the brush base 51 of the implanted flat brush 50, and the cleaning solution that contains 4.20 wt% or less of the surface active agent.

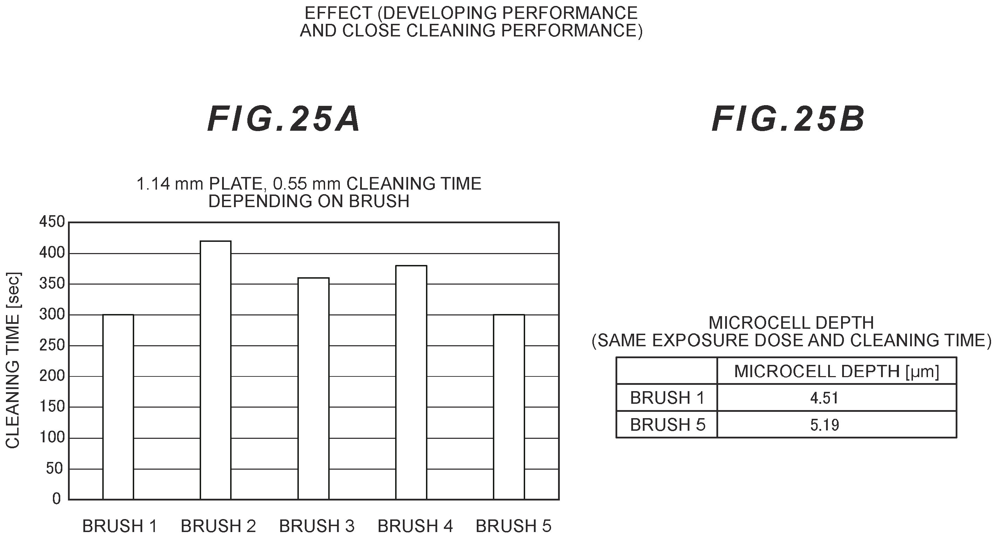

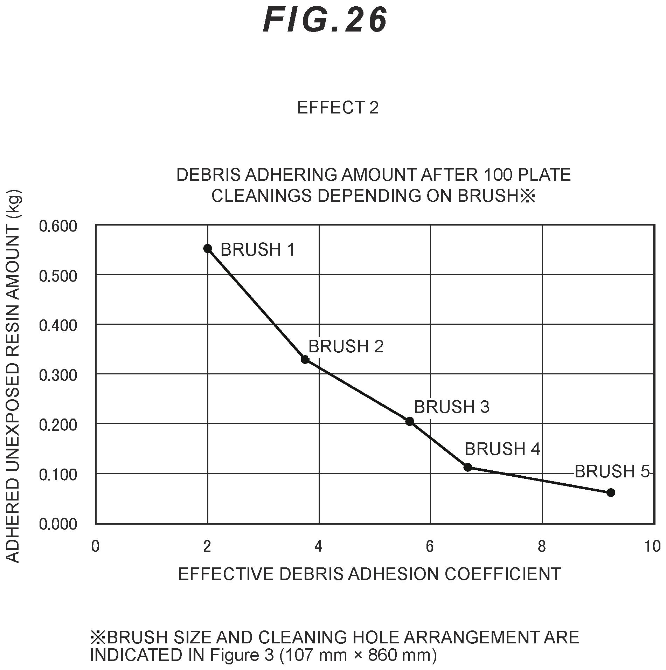

A preferable range of the debris adhesion coefficient S/L was 6.00 or more and 12.00 or less. If the debris adhesion coefficient S/L of the implanted flat brush 50 is in this range, the bristle bundle density is lower, but the bristle height of the brush is relatively shorter, compared to the brushes 1 to 3 of which debris adhesion coefficients are outside this range. Hence the debris adhesion to the brush dramatically decreases even when the cleaning time (productivity of the printing plate) is the same. The debris adhesion amount to the brush was measured using the brush size of 107 mm × 860 mm (see Figure 26). It was also discovered that in this range of debris adhesion coefficient S/L, the cleaning solution flows faster among the bristle bundles, and the removal performance of the unexposed resin improves in the cleaning of fine portions (microcells) of which distance between recessed portions is 30 µm or less. To measure the depth of the microcells, a laser microscope VK-X1000, made by Keyence Corp., was used (see Figure 25B).

Further, more space can be secured and the cleaning solution can be spread more uniformly compared with the brushes 1 to 3, of which debris adhesion coefficients are outside the preferable range, hence the debris adhesion to the brush dramatically decreases even when the cleaning time (productivity of the printing plate) is the same. In this respect, it is preferable that the implanted flat brush 50 is configured as follows. For example, it was preferable that a base area L formed by 4 bristle bundles 53 in close proximity is 110.00 [mm2] or more and 200.00 [mm2] or less, and the bristle height L of the bristle bundle 53 is 8.00 [mm] or more and less than 20.00 [mm]. Further, in the area formed by the 4 bristle bundles 53 in close proximity, it was preferable that a ratio of the bristle height L of the bristle bundle 53 and a distance between two implanting holes in close proximity is 0.70 or more and 1.30 or less. For example, in the case where the bristle height L is 13 mm, and the bristle bundle distances in two directions are 10 mm and 12 mm, the ratio is 1:0.76:0.92 (see Figure 19). Further, in a case where cleaning holes 54 (discharge ports of cleaning solution) are formed on the flat brush base 51, it was preferable that these cleaning holes 54 are disposed in the zigzag arrangement, for example (see Figure 20). It was preferable that the distance between the cleaning holes 54 in close proximity is 65.00 [mm] to 80.00 [mm], and a number of bristle bundles 53 between the cleaning holes 54 in close proximity is 3 to 7 (see Figure 20).

In the case of the implanted flat brush 50 in which the bristle bundles 53 are arranged in a line at equal intervals, it was preferable that the distance between the adjacent bristle bundles 53 across the cleaning hole 54 is 3.00 times or less of the distance between the adjacent bristle bundles 53 not across the cleaning hole 54. Specifically, in a case of replacement with the cleaning holes 54 at the locations of the bristle bundles 53, in the parallel arrangement (see Figure 28), for example, of all 3 continuous bristle bundles 53 replaced with the cleaning holes 54, the bristle bundles 53 become sparce, and performance of removing unexposed resin drops, hence this kind of arrangement should be avoided. In other words, to prevent the cleaning holes 54 from taking over the positions of the bristle bundle 53 which should be disposed, it is preferable to limit a number of bristle bundles 53 to be replaced by cleaning holes 54 to a maximum of 2 by appropriately adjoining the distance between the bristle bundles 53. Further, in the case of replacing the positions of the bristle bundles 53 with the cleaning holes 54 in a parallel arrangement (see Figure 28), for example, it is preferable to avoid replacing both the two bristle bundles 53 disposed side-by-side with the cleaning holes 54.
▪ In the implanted flat brush 50, it was preferable that the distance between the bristle bundle 53 and another bristle bundle 53 closest to this bristle bundle 53 is 4.00 mm or more and 16.00 mm or less (see Figure 20 to Figure 26). In this case, cleaning performance can be ensured and the adhesion of debris to the brush can be prevented, thereby brush maintainability improves and plate quality can be guaranteed.
▪ When the brush base 51 of the implanted flat brush 50 is rectangular, it was preferable that the ratio of the short side and the long side is1.00:6.00 or more and 1.00:10.00 or less. In this case, attachment and detachment of the implanted flat brush 50 is easy and maintainability improves.
▪ A number of implanting holes 52 of the implanted flat brush 50 was preferably000/m2 or more and 15000/m2 or less, and more preferably 7000/m2 or more and 9000/m2 or less (see Figure 18, Figure 25 and Figure 26).
▪ The bristle diameter of each bristle of the bristle bundle 53 of the implanted flat brush 50 was preferably from 80.00 µm or more and 400.00 µm or less, and more preferably 100.00 µm or more and 300.00 µm or less (see Figure 18, Figure 25 and Figure 26).
▪ The bristle amount of the bristle bundles 53 of the implanted flat brush 50 was preferably 0.50 kg/m2 or more and 1.20 kg/m2 or less, and more preferably 0.70 kg/m2 or more and 1.00 kg/m2 or less (see Figure 18, Figure 25 and Figure 26).
▪ A number of bristles of the bristle bundle 53 of the implanted flat brush 50 was preferably 250/hole or more and 400/hole or less, and more preferably 300/hole or more and 350/hole or less (see Figure 18, Figure 25 and Figure 26).
▪ The hole diameter of the implanting hole 52 of the implanted flat brush 50 was preferable 4.00 mm or more and 5.00 mm or less (see Figure 18, Figure 25 and Figure 26).
▪ It was preferable that the ratio of the depth of the implanting hole 52 and the bristle height L of the implanted flat brush 50 is5.0:13.0 or more and 30.0:13.0 or less, and the ratio of the depth of the implanting hole 52 and the hole diameter is 5.0:4.2 or more and 30.0:4.2 or less(see Figure 25 and Figure 26).
▪ The maximum depth of the implanting hole 52 of the implanted flat brush 50 was preferably 5.00 mm or more and 20.00 mm or less, and more preferably 5.00 mm or more and 15.00 mm or less (see Figure 25 and Figure 26).
▪ It was preferable that the material of the brush base 51 of the implanted flat brush 50 is any of or two or more of PVC, PP and ABS, and the material of the bristles is one of 66 NY, 612 NY, 610 NY and PP.

### Industrial Applicability

The present invention is preferably applicable to the implanted flat brush or the implanted roll brush used in the developing step of the printing plate.

### Reference Signs List

- 10: Implanted roll brush
- 20: Brush base
- 20A: Rotation shaft
- 30: Implanting hole
- 40: Bristle bundle
- 41: Bristle
- 50: Implanted flat brush
- 51: Brush base
- 52: Implanting hole
- 53: Bristle bundle
- 54: Cleaning hole (discharge port of cleaning solution)
- 100: Cleaning apparatus
- 300: Printing plate developing step system
- 310: Developer tank
- 320: Developer filtering apparatus
- 330: Developer suction apparatus
- 340: Dispersoid filter
- 350: Aggregate filter
- L: Bristle height of bristle bundle [mm]
- S: Smallest base area (smallest base area formed by 4 bristle bundles in close proximity)
- S/L: Debris adhesion coefficient

## Claims

1. An implanted flat brush or implanted roll brush used for a developing step of a printing plate, which is made through an exposing step and the developing step, wherein
bristle bundles are implanted at equal intervals into a plurality of implanting holes formed in a brush base, and in a case where a smallest base area that is formed by four bristle bundles in close proximity is S [mm2] and a bristle height of the bristle bundle is L [mm], a debris adhesion coefficient S/L is 6.00 or more and 12.00 or less.

2. The implanted flat brush or implanted roll brush according to claim 1, wherein
a base area formed by four bristle bundles in close proximity is 110.00 [mm2] or more and 200.00 [mm2] or less,
the distance between the bristle bundle and another bristle bundle closest to the bristle bundle is 4.00 [mm] or more and 16.00 [mm] or less,
in the region formed by the four bristle bundles in close proximity, a ratio of the bristle height L of the bristle bundle and a distance between two implanting holes in close proximity is 0.70 or more and 1.30 or less,
the bristle height L of the bristle bundle is 8.00 [mm] or more and 20.00 [mm] or less,
a number of the implanting holes is 4000/m2 or more and 15000 /m2 or less,
a depth of the implanting hole is 5 mm or more and 20 mm or less, and
a ratio of the depth of the implanting holes and the bristle height is 5.0:13.0 or more and 30.0:13.0 or less.

3. An implanted flat brush or implanted roll brush used for a developing step of a printing plate, which is made through an exposing step and the developing step, wherein
brush bundles are implanted into a plurality of implanting holes formed in a brush base,
a bristle height of the bristle bundle is 8 mm or more and 20 mm or less,
a depth of the implanting hole is 5 mm or more and 20 mm or less,
a ratio of the depth of the implanting hole and the bristle height is 5.0:13.0 or more and 30.0:13.0 or less, and
a number of the implanting holes is 4000/m2 or more and 15000/m2 or less.

4. The implanted flat brush or implanted roll brush according to claim 3, further comprising a rinsing step to make the printing plate.

5. The implanted flat brush or implanted roll brush according to claim 1, wherein
cleaning holes, which are discharge holes for cleaning solution, are formed on a flat brush base, the cleaning holes are disposed in a zigzag arrangement, a distance between the cleaning holes in close proximity is 65.00 [mm] or more and 80.00 [mm] or less, and a number of bristle bundles between the cleaning holes in close proximity is 3 or more and 7 or less.

6. The implanted flat brush or implanted roll brush according to claim 5, wherein
in the bristle bundles which are disposed in a line at equal intervals, a distance between bristle bundles which are adjacent to each other across the cleaning hole is 3,000 times or less of a distance between bristle bundles which are adjacent to each other not across the cleaning hole.

7. The implanted flat brush or implanted roll brush according to any one of claims 1 to 6, wherein
a bristle diameter of each bristle of the bristle bundle is 80 µm or more and 400 µm or less,
a bristle amount of the bristle bundle is 500 g/m2 or more and 4000 g/m2 or less,
a hole diameter of the implanting hole is 1.0 mm or more and 6.0 mm or less,
a number of bristles is 100/hole or more and 500/hole or less,
a ratio of the depth of the hole and the hole diameter is 5.0:4.2 or more and 30:4.2 or less,
the brush base is formed of resin, and
a material of the brush base is any of or two or more of PVC, PP and ABS, and a material of the bristle is any of 66 NY, 612 NY, 610 NY and PP.

8. The implanted flat brush according to any one of claims 1 to 6, wherein
the brush base is rectangular, the ratio of a short side and a long side of which, is 1:6.00 or more and 1:10.00 or less.

9. A method for manufacturing a printing plate, the method comprising an exposing step and a developing step, wherein
in an implanted flat brush or implanted roll brush used in the developing step, bristle bundles are implanted at equal intervals into a plurality of implanting holes formed in a brush base, and
in a case where a smallest base area formed by four bristle bundles in close proximity is S [mm2] and a bristle height of the bristle bundle is L [mm], a debris adhesion coefficient S/L is 6.00 or more and 12.00 or less.

10. A method for manufacturing a printing plate, the method comprising an exposing step and a developing step, wherein
in an implanted flat brush or implanted roll brush used in the developing step, bristle bundles are implanted into a plurality of implanting holes formed in a brush base,
a bristle height of the bristle bundle is 8 mm or more and 20 mm or less,
a depth of the implanting hole is 5 mm or more and 20 mm or less,
a ratio of the depth of the implanting hole and the bristle height is 5.0:13.0 or more and 30.0:13.0 or less, and
a number of the implanting holes is 4000/m2 or more and 15000/m2 or less.

11. The method for manufacturing a printing plate according to claim 9 or 10, wherein
a rotating speed of the brush in the developing step is 3 rpm or more and 25 rpm or less, and an oscillating speed during oscillating rotation is 20 rpm or more and 150 rpm or less.

12. The method for manufacturing a printing plate according to claim 9 or 10, wherein
a contact pressure of the brush to the printing plate in the developing step is 50 g/cm2 or more and 800 g/cm2 or less, and a biting amount of the brush to the printing plate is 1 mm or more and 5 mm or less.

13. The method for manufacturing a printing plate according to claim 9 or 10, further comprising the steps of:
selecting a brush that is appropriate for design and/or quality of the plate; and
adjusting a brush contact pressure by installing a spacer at a root of the brush base.

14. The method for manufacturing a printing plate according to claim 9 to 10, wherein
the flat brush includes two or more types of regions of which thickness, length and material of a bristle are different.

15. The method for manufacturing a printing plate according to claim 9 or 10, wherein
developer is used in the developing step, and the developer contains a surface active agent of which content percentage is 0.00 wt% or more and 4.20 wt% or less.

16. A printing plate developing step system used for a developing step of a printing plate, which is made through an exposing step and the developing step, the system being a developer processing system including: the implanted flat brush or implanted roll brush according to any one of claims 1 to 6; a developer tank; and a developer filtering apparatus, which includes at least one filter, wherein
in an unexposed resin mass balance in a case where an unexposed resin is supplied into the system, a total of resin existing in the developer filtering apparatus and resin floating in the developer tank is 70.0 wt% or more and 95.0 wt% or less with respect to the supplied unexposed resin.

17. The developer processing system according to claim 16, wherein
the developer tank includes a developer suction apparatus, and
the developer filtering apparatus filters developer sucked by the developer suction apparatus, and includes: a dispersoid filter which aggregates dispersoid dispersed in the developer; and an aggregate filter which removes aggregates aggregated by the dispersoid filter.
